Europäisches Patentamt

**European Patent Office**

Office européen des brevets

(11) Veröffentlichungsnummer: **0 156 150**
**B1**

(12) **EUROPÄISCHE PATENTSCHRIFT**

(45) Veröffentlichungstag der Patentschrift:
**01.06.88**

(51) Int. Cl.⁴: **H 05 K 13/04, H 05 K 13/00**

(21) Anmeldenummer: **85101608.9**

(22) Anmeldetag: **14.02.85**

(54) **Vorrichtung zur automatischen Verarbeitung elektrischer Bauelemente.**

| | |
|---|---|
| (30) Priorität: **18.02.84 DE 3405971**<br>**28.02.84 DE 3407234** | (73) Patentinhaber: **Sillner, Georg, Buchenstrasse 23,**<br>**D-8411 Zeitlarn (DE)** |
| (43) Veröffentlichungstag der Anmeldung:<br>**02.10.85 Patentblatt 85/40** | (72) Erfinder: **Sillner, Georg, Buchenstrasse 23,**<br>**D-8411 Zeitlarn (DE)** |
| (45) Bekanntmachung des Hinweises auf die Patenterteilung:<br>**01.06.88 Patentblatt 88/22** | (74) Vertreter: **Graf, Helmut, Dipl.-Ing. et al, Greflinger**<br>**Strasse 7 Postfach 382, D-8400 Regensburg (DE)** |
| (84) Benannte Vertragsstaaten:<br>**AT BE CH DE FR GB IT LI NL** | |
| (56) Entgegenhaltungen:<br>**DE - A - 2 820 831**<br>**DE - A - 3 002 010**<br>**DE - A - 3 335 905**<br>**FR - A - 2 306 598**<br>**GB - A - 1 105 869**<br>**US - A - 3 878 026**<br>**US - A - 4 356 949** | |

**Beschreibung**

Die Erfindung bezieht sich auf eine Vorrichtung zur automatischen Verarbeitung elektrischer Bauelemente, die jeweils in einer von mehreren Magazinen gebildeten Magazinanordnung in radial gegurteter Form auf von Gurten gebildeten Rollen (Spulen) oder auf zick-zack-förmig gefalteten Gurten in Schachteln bereitstehen, wobei jeder Gurt jeweils Bauelemente des gleichen Typs aufweist und unterschiedliche Gurte unterschiedliche Bauelemente tragen. Die Bauelemente werden in einer ersten Einrichtung aus den Magazinen programmgesteuert abgerufen und auf ein Transportelement übergeben, an welchem dann Bauelemente unterschiedlichen Typs in einer für die spätere Bestückung einer elektrischen Schaltung (z.B. Printplatte) erforderlichen Sequenz angeordnet sind. Mit dem Transportelement werden die Bauelemente in der erstellten Sequenz an eine Übergabestation transportiert und dort an eine zweite Einrichtung übergeben, die entweder eine Aufgurtstation zum erneuten Aufgurten der Bauelemente auf einem gemeinsamen Gurt in der erstellten Sequenz oder aber ein Bestückkopf ist, mit dem die Bauelemente in der erstellten Sequenz in eine elektrische Schaltung (Printplatte) eingesetzt werden. Eine derartige Vorrichtung ist aus der DE-A-3 002 010 bekannt.

Bekannt sind Vorrichtungen zum erneuten Aufgurten von elektrischen Bauelementen in einer erstellten Sequenz. Der mit diesen Einrichtungen erhaltene Gurt wird in Bestückungsautomaten für elektrische Schaltungen verwendet, die keine Einrichtung zur Sequenzbildung aufweisen, wobei dann bevorzugt eine solche Vorrichtung zum erneuten Aufgurten zusammen mit mehreren Bestückungsautomaten verwendet wird, die dann eine relativ einfache Konstruktion aufweisen können.

Nachteilig ist bei diesen bekannten Vorrichtungen zum erneuten Aufgurten, dass diese vor allem auch hinsichtlich der Ausbildung des Transportelementes und dessen Aufnahmen für die Bauelemente eine aufwendige Konstruktion aufweisen und relativ grosse Massen bewegt werden müssen, die nur eine relativ geringe Leistung zulassen und das genaue Positionieren der Aufnahmen des in der Regel getaktet angetriebenen Transportelementes erschweren.

Bekannt sind weiterhin Bestückungsautomaten mit einer Einrichtung zur Sequenzbildung für radial gegurtete Bauelemente. Diese lassen sich grundsätzlich in zwei Gruppen klassifizieren.

Bei bekannten Maschinen (TDK/UNIVERSAL) einer ersten Gruppe werden die Bauelemente während der Sequenzbildung und des Transportes von den Magazinen an den Bestückkopf direkt an ihren Anschlussdrähten gehalten. Diese Art der Halterung ist sehr sensibel, insbesondere auch gegen Störungen (beispielsweise Verbiegen der Anschlussdrähte). Da die Anschlussdrähte von Bauelementen unterschiedlichen Typs im Querschnitt stark variieren können, ergeben sich erhebliche Schwierigkeiten. Weiterhin ist es bei diesen bekannten Maschinen nicht möglich, auf ein universelles Rastermass zu arbeiten. Ein ganz entscheidender Nachteil besteht auch darin, dass die einmal hergestellte Sequenz von Bauteilen, z.B. bei einer Fehlbestückung nicht mehr reparierbar ist und deshalb von Hand nachbestückt werden, siehe die DE-A-2 820 831, muss. Ein Reparierprogramm ist nicht möglich.

Bei bekannten Maschinen (PANASERT/FUJI) ist es notwendig, den gesamten Bauelementevorrat, d.h. die Magazine mit den an den Gurten gehaltenen Bauelementen, zugehörige Schneidvorrichtungen und Einrichtungen zum Vorschub der Bauelemente aus den Magazinen in der Weise bewegt werden, dass das dem jeweils benötigten Bauelement entsprechende Magazin an die Bestückzangenanordnung bzw. Bestückkopf heranbewegt und nach der Entnahme des Bauelementes wieder wegbewegt wird. Nachteilig ist bei diesen bekannten Maschinen, dass grosse Massen während der Bestückung einer elektrischen Schaltung bewegt werden müssen, wodurch die Bestückungsgeschwindigkeit relativ gering ist. Auch ist ein fliegender Wechsel des Magazinvorrats nicht möglich. Die Maschine muss für den Wechsel vielmehr angehalten werden. Allen vorstehend erwähnten Systemen ist der Nachteil gemeinsam, dass es nicht oder nur mit ausserordentlich grossem Aufwand möglich ist, drei- oder mehrbeinige radial gegurtete Bauelemente zu bestücken, weil mit den Bestückzangen der mittlere Draht oder die mittleren Drähte zum definierten Einsetzen in die Printplatte nicht eindeutig festgehalten werden können. Weiterhin ist es nicht möglich, Bauelemente mit verschiedenen Rastermassen, d.h. Abständen der Anschlussdrähte, ohne Auswechslung der Zangensysteme zu verarbeiten. Beispielsweise ist für das System FUJI ein eigener Bestückkopf für jedes Rastermass notwendig. Es wurde deshalb nach dem Revolverprinzip eine sehr aufwendige Bestückkopfwechseleinrichtung geschaffen. Weiterhin haben alle vorgenannten Systeme den Nachteil gemeinsam, dass hochkomplizierte Schneid- und Biegewerkzeuge unterhalb der Printplatte zum Schneiden und Umbiegen der vorstehenden Drahtstummel benötigt werden. Ein Entfernen dieser Drahtstummel auf kleinstem Raum ist hierbei sehr schwierig, da an dieser Stelle der Schneidvorrichtung eine Messvorrichtung zugeordnet sein muss, die nochmals das Vorhandensein der Anschlussdrähte überprüft. Generell haben alle vorgenannten bekannten Bestückautomaten den Nachteil, dass sie relativ grosse Dimensionen, einen hohen Platzbedarf und ein hohes Gewicht haben sowie relativ aufwendig im Aufbau sind. Auch ist es bei keinem System möglich, alle Bauelemente vor dem Bestücken vollständig elektrisch und mechanisch zu prüfen.

Aufgabe der vorliegenden Erfindung ist es, eine Vorrichtung aufzuzeigen, welches bzw. welche es bei geringem verfahrenstechnischen und konstruktiven Aufwand gestattet, radial gegurtete Bauelemente in ebenfalls radialer Form und in der für die Bestückung einer elektrischen Schaltung erforderlichen Sequenz an eine Übergabestation und von dort an eine Einrichtung zur weiteren Verwendung der Bauelemente zu transportieren, welch letztere entweder eine Aufgurtstation oder aber bevorzugt der Bestückkopf ist, so dass die Vorrichtung dann einen Bestückungsautomaten mit Einrichtung zur Sequenzbildung darstellt.

Weiterhin ist es Aufgabe der Erfindung, eine gegen schlechte Bauteilqualität unempfindliche, universelle, einfache und preiswerte Vorrichtung zu schaffen, die vor allem auch eine Mehrfachübergabe von Bauelementen an das Transportelement sowie auch an die zweite Einrichtung zur weiteren Verwendung vermeidet, um die Betriebssicherheit zu erhöhen, die ein Auswechseln der Gurte an den Magazinen ohne Unterbrechung der Arbeitsweise der Vorrichtung zulässt, die in gleicher Weise ohne jedes Umrüsten Bauelemente mit einem, mit zwei, mit drei oder mit vier oder mit mehreren Anschlussdrähten verarbeiten kann, die bei Ausbildung als Bestückautomat das Schneiden des Drahtüberstandes der Anschlussdrähte unter der Printplatte überflüssig macht, die eine Vorwärts- und Rückwärtsbewegung des Transportelementes (Sequenzbandes) zu Reparaturzwecken zulässt, die bei ihrer Ausbildung als Bestückungsautomaten die Bauelemente am Transportelement ohne weitere Übergabe in eine senkrechte Position bringt und sie direkt an eine Bestückungszange des Bestückungskopfes übergibt, welche dann alle Anschlussdrähte jedes Bauelementes zentriert und einzeln festspannt, die es vor allem auch ermöglicht, dass alle Bauelemente bereits auf dem Transportelement im Durchlauf auf Vorhandensein, auf elektrische Funktion, mechanische Masshaltigkeit und Typisierung geprüft werden.

Zur Lösung dieser Aufgabe ist eine Vorrichtung gemäss dem kennzeichnenden Teil des Anspruchs 1 ausgebildet. Weitere Ausgestaltungen der Erfindung sind Gegenstand der Unteransprüche.

Bei der erfindungsgemässen Vorrichtung ist das Transportelement bevorzugt ein in sich geschlossenes, endloses gurt- oder bandförmiges Element, welches dann bevorzugt zahnriemenförmig ausgebildet ist und aus zwei parallel zueinander und im Abstand voneinander angeordneten, endlosen Einzelelementen besteht, die durch quer zur Transportrichtung des Transportelementes liegende Stege miteinander verbunden sind, die die Aufnahmen für die Bauelemente bilden. Diese sind an den durch Abschneiden der Gurte erhaltenen Gurtabschnitten gehalten, welche im Bereich ihrer Lochleibungen an Zapfen oder Stiften der Aufnahmen zentriert und eingespannt sind.

Sofern die erfindungsgemässe Vorrichtung als Bestückautomat mit einem dem Transportelement nachgeschalteten Bestückungskopf ausgebildet ist, ist das Transportelement an der Übergаbestelle bevorzugt um eine Umlenkrolle geführt, so dass die Bauelemente auf dem Transportelement beim Erreichen der Umlenkrolle mit ihrem Kopf gegenüber dem nachfolgenden Teil des Transportelementes geschwenkt und vorzugsweise in eine vertikale Position gebracht werden, in der die Bauelemente dann bequem von der Bestückzange des Bestückungskopfes ergriffen werden können. Der Bestückungskopf bzw. dessen Bestückungszange sind um 360° schwenkbar und im übrigen auch so gesteuert und ausgebildet, dass die Bestückungszange den absolut geringsten Seitenabstand zu benachbarten Bauelementen auf der Printplatte zulässt und damit die grösstmöglichste Bestückungs- bzw. Packungsdichte erlaubt.

Alle Bauelemente können bei der erfindungsgemässen Vorrichtung in den zum Zuführen dienenden Gurten in einer einheitlichen Eingurthöhe eingegurtet werden, wobei auch Bauelemente mit unterschiedlichem Querschnitt und vor allem auch unterschiedlichem Durchmesser der Anschlussdrähte mit höchster Funktionssicherheit verarbeitet werden können.

Diese Aufgabe wird gemäss der Erfindung mit den Merkmalen des Kennzeichens des Anspruches 1 sowie des Anspruches 4 gelöst. Weitere Ausgestaltungen der Erfindung sind Gegenstand der Unteransprüche.

Aufbau und Arbeitsweise einer Vorrichtung nach der Erfindung sind wie folgt:

Mit der Erfindung ist ein Verfahren zur automatischen Verarbeitung elektrischer Bauelemente möglich, bei welchem die Bauelemente in einer ersten Einrichtung zur Sequenzbildung, in der die Bauelemente in Magazinen auf mehreren Gurten mit Perforationslöchern in radial gegurteter Form bereitstehen, wobei jeder Gurt Bauelemente des gleichen Typs trägt, programmgesteuert an Ladepositionen aus den Magazinen abgerufen und in einer für die Bestückung einer elektrischen Schaltung erforderlichen Sequenz mit Hilfe eines Transportelementes an eine Übergabestation gefördert werden, an der die Bauelemente an eine zweite Einrichtung zur Weiterverarbeitung übergeben werden, wobei für die Übergabe jedes Bauelementes an das getaktet umlaufende Transportelement der betreffende Gurt im Bereich zwischen diesem Bauelement und einem nachfolgenden Bauelement mittig an einem Perforationsloch quer zur Gurtlaufrichtung (Gurtlängsrichtung) abgeschnitten und der dadurch erhaltene, ein Bauelement tragende Gurtabschnitt derart an das Transportelement übergeben wird, dass der Gurtabschnitt an seinen Lochleibungen am Transportelement zentriert und festgehalten ist. Die Transportrichtung der abgeschnittenen Bauelemente auf dem Transportelement liegt in Achsrichtung der Anschlussdrähte dieser Bauelemente in Gurtebene und quer zur Gurtlaufrichtung liegt.

Das Verfahren mit der erfindungsgemässen Vorrichtung ist vorzugsweise so ausgestaltet, dass bei einer Um- oder Neugurtung der Bauelemente in einer für die Bestückung einer Schaltung benötigten Sequenz die Gurtabschnitte mit den Bauelementen nacheinander an der Übergabestation an ein weiteres Transportelement übergeben werden, an welchem die Gurtabschnitte in unmittelbarer Folge aufeinander an ihren Lochlaibungen zentriert und gehalten sind und zu einem gemeinsamen Gurt miteinander verbunden werden, oder dass zur Bestückung einer mit Löchern versehenen Printplatte die Bauelemente an der Übergabeposition in eine stehende Position gebracht, an dieser Stelle an den Anschlussdrähten zentriert und eingeklemmt sowie die Anschlussdrähte ausgerichtet werden, dass im eingespannten Zustand jedes Bauelementes eine Bestückungsvorrichtung zwischen die Anschlussdrähte des Bauelementes eingefahren wird und alle Anschlussdrähte des Bauelementes festgehalten werden, dass die zentrierten und eingespannten Anschlussdrähte unterhalb der die zweite Einrichtung bildenden Bestückungsvorrichtung von dem Gurtabschnitt freigeschnitten werden, in dem ein bewegliches Schneidmesser gegen ein starres Schneidmesser derart arbeitet, dass die Anschlussdrähte in definierter Weise auf endgültige Länge abgeschnitten werden, und dass die frei geschnittenen Bauelemente von der Bestückungsvorrichtung aus der Zentrier- und Einspannposition abgehoben, in die auf der Printplatte vorgegebene Position bewegt und in die entsprechenden Löcher der Printplatte abgesenkt werden, wobei vorzugsweise in an sich bekannter Weise die aus der Unterseite der Printplatte vorstehenden Anschlussdrähte auf einwandfreie Position geprüft und gleichzeitig umgebogen werden.

Die Radialbauelemente werden aus einer Magazinanordnung von Rollen oder zick-zackförmig gefaltet aus Schachteln seitlich in die Vorrichtung eingeführt. Dies kann entweder durch ein auf einer Seite der Vorrichtung angeordnetes Magazin, oder aber aus zwei Magazinen geschehen, die auf entgegengesetzten Seiten zur Längsachse der Vorrichtung und spiegelbildlich zueinander angeordnet sind, so dass die radial gegurteten Bauelemente von beiden Seiten in gleicher Positionierung in den Automaten eingeführt werden. Es wird jeweils das Gurtband der Rolle vorgeschoben und das Bauelement vom Gurtband abgetrennt, das aufgrund der Programmsteuerung auf dem Transportelement benötigt wird. Die Radialbauelemente werden in Gurtlaufrichtung der Rolle taktweise entnommen, einzeln abgeschnitten und in vereinzeltem Zustand auf das Transportelement tung übergeben und dabei in Kartonebene (Gurtebene) quer zur Gurtlaufrichtung, also in Achsrichtung der Anschlussdrähte durch die Vorrichtung transportiert. Durch eine Förderung der Bauelemente in Achsrichtung der Radialbauelemente bzw. der Anschlussdrähte mit nacheilendem Bauelementekopf und voreilendem Karton wird die schonendste und zweckmässigste Beförderung erreicht, da die Klebestelle in Achsrichtung am widerstandsfähigsten ist und jede auf das Teil einwirkende Querbeschleunigung das Ablösen des Klebebandes vom Karton (Gurtabschnitt) verursachen kann. Die vereinzelten Gurtabschnitte mit darauf befindlichem Radialbauelement werden auf dem vorzugsweise leiterförmigen Transportriemen, z.B. einem Zahnriemen, getaktet durch die Vorrichtung transportiert. Der Riemen besitzt einen Freiraum zur Aufnahme des Kopfes des Bauelementes und der Stege, und die Gurtbandabschnitte werden an den Laibungen der durchtrennten Perforationslöcher (Transportlöcher) unter Vorspannung auf am Transportelement vorgesehenen Zapfen zentriert und durch Klemmsitz festgehalten. Der Transport der Gurtbandteile an den Laibungen der Perforationslöcher ergibt ein Optimum an Genauigkeit, da der Abstand der Perforationslöcher voneinander wesentlich exakter ist als beispielsweise der Abstand der Anschlussdrähte eines Bauelementes voneinander.

Bei der Ausbildung als Bestückautomat fährt nach dem Einsetzen der Anschlussdrähte eines Bauelementes mit der Bestückzange in in die Printplatte ein starr über dem Bestückkopf angeordneter Druckluftzylinder eines Eindrückers seinen Stössel aus, der mit einer Gummikappe versehen ist. Dieser Stössel drückt auf das Bauteil, die Bestückzange öffnet sich und fährt aus dem Bauteil heraus. Der Eindrücker drückt das Bauelement anschliessend vollständig auf die Printplatte, unterhalb welcher Biegewerkzeuge vorgesehen sind, die die Anschlussdrähte umbiegen und die gleichzeitig prüfen, ob die Anschlussdrähte vollzählig vorhanden sind.

Insbesondere ist die Vorrichtung besonders einfach im Aufbau, universell in der Anwendung und unempfindlich gegen schlechte Gurtqualität, da aufgrund des Zahnriementransportes in Verbindung mit der Einspannung der Gurtbandteile in die Ansätze der Querstege eine ausserordentlich hohe Genauigkeit des Transportes erzielt wird und beim gesamten Transport die Bauelemente bzw. ihre Anschlussdrähte selbst beim Transport nicht beansprucht werden. Es ist dabei für die Arbeitsweise der Vorrichtung auch in Ausbildung als Bestückautomat unerheblich, ob Bauelemente mit einem, mit zwei, mit drei, mit vier oder mit mehr Anschlussdrähten verarbeitet werden sollen. Ferner werden die Bauelemente bei der Übergabe vom Gurtband auf die Transportvorrichtung wie auch bei der Übergabe von der Transportvorrichtung in die Einrichtung zur weiteren Verarbeitung, z.B. Bestückzange stets in exakter Weise zentriert und positioniert, so dass von der Normstellung abweichende Anschlussdrähte der Bauelemente hierbei wieder einwandfrei ausgerichtet werden.

Besonders vorteilhaft ist bei der als Bestückautomat ausgeführten Vorrichtung auch, dass die Stummel der Anschlussdrähte, die nach dem Einsetzen in die Printplatte unten aus der Printplatte vorstehen, nicht mehr geschnitten werden brauchen, da sie bereits an der Übergabestation auf die fertige Länge geschnitten werden können.

Ein weiterer entscheidender Vorteil der Erfindung besteht darin, dass in besonders einfacher Weise ein Reparierprogramm durchgeführt werden kann, das eine minimale Ausfallzeit der Vorrichtung gewährleistet, so dass jede Position des Sequenzbandes erforderlichenfalls innerhalb kürzester Zeit neu besetzt werden kann.

Nachstehend wird die Erfindung in Verbindung mit den Figuren an Ausführungsbeispielen näher erläutert. Es zeigen:

Fig. 1 eine Blockdarstellung des prinzipiellen Aufbaus der erfindungsgemässen Vorrichtung;

Fig. 2 in schematischer Draufsicht eine erste Ausführungsform der Vorrichtung in Form einer Einrichtung zum Umgurten von radial gegurteten elektrischen Bauelementen unterschiedlichen Typs auf einem gemeinsamen Gurt in einer für die Bestückung einer elektrischen Schaltung benötigten Folge (Sequenz);

Fig. 3 und 3a in Seitenansicht (Blickrichtung entsprechend dem Pfeil A) die Vorrichtung gemäss Fig. 2 sowie ein Detail bei einer abgewandelten Ausführung;

Fig. 4 eine ähnliche Ansicht wie Fig. 3, jedoch in perspektivischer Darstellung;

Fig. 5 in perspektivischer Ansicht eine Teildarstellung der Übergabe (Ladeposition) der elektrischen Bauelemente aus den einzelnen Magazinen und ihre Förderung auf dem ersten Transportelement;

Fig. 6 bis 8 einen Transportteller des Transportelementes im Längsschnitt, Querschnitt sowie in perspektivischer Darstellung;

Fig. 9 im seitlichen Schnitt eine Schneidvorrichtung zum Abschneiden der jeweils an einem Gurtabschnitt gehaltenen Bauelemente von dem diese Bauelemente tragenden Gurt in jedem Magazin, bei in Ruhestellung befindlichem Schneidbalken;

Fig. 10 eine Draufsicht auf die Schneidvorrichtung gemäss Fig. 9;

Fig. 11 eine Darstellung eines Vorschubantriebes für die in den Magazinen vorgesehenen Gurte;

Fig. 12 einen Schnitt durch einen Ausschnitt des Vorschubantriebs entsprechend der Linie III–III;

Fig. 13 mehrere elektrische Bauelemente unterschiedlichen Typs in der umgegurteten Form;

Fig. 14 in Einzelansicht und in Seitendarstellung eine an der Einrichtung zur Sequenzbildung vorgesehene Übergabestation bei der Vorrichtung gemäss Fig. 2, zusammen mit einem zweiten Transportelement der Einrichtung zur Weiterverarbeitung der Bauelemente;

Fig. 15 eine Draufsicht auf die Übergabestation gemäss Fig. 14;

Fig. 16 eine Vorrichtung zum Entfernen von fehlerhaften Bauelementen vom ersten Transportelement;

Fig. 17 eine perspektivische Ansicht einer zweiten Ausführungsform in Form eines Bestückungsautomaten;

Fig. 18 einen Schnitt in Richtung der Längsmittelachse IV–IV des Bestückungsautomaten;

Fig. 19 einen Schnitt in Richtung der Querachse V–V des Bestückungsautomaten;

Fig. 20 bis 22 die Übergabe der Bauelemente vom Transportelement an den Bestückungskopf des Bestückungsautomaten;

Fig. 23 und 24 schematische Darstellungen der Zangen des Bestückungskopfes, jeweils bei geschnittenem Zangenkopf und in Draufsicht auf den Zangenkopf, bei zweibeinigen bzw. dreibeinigen Bauelementen;

Fig. 25 eine abgewandelte Ausführungsform des Zangenkopfes;

Fig. 26 eine Draufsicht auf den Bestückungskopf;

Fig. 27 einen Schnitt entlang der Linie VI–VI;

Fig. 28 in Einzeldarstellung eine Seitenansicht der Zange;

Fig. 29 eine Ausführungsform der Bestückungskopf-Verstellung in Draufsicht;

Fig. 30 eine Seitenansicht der Fig. 29;

Fig. 31 Beispiele für das Bestücken einer Printplatte bzw. deren Eckpunkte mit Bauelementen;

Fig. 32 in Seitenansicht eine dritte Ausführungsform in Form eines Bestückungsautomaten;

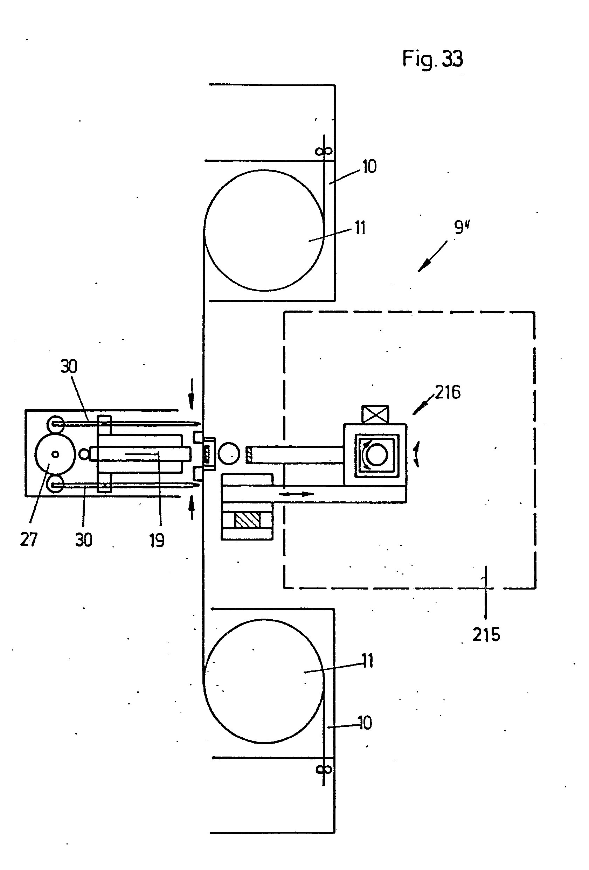

Fig. 33 eine Draufsicht auf den Bestückungsautomaten nach Fig. 32.

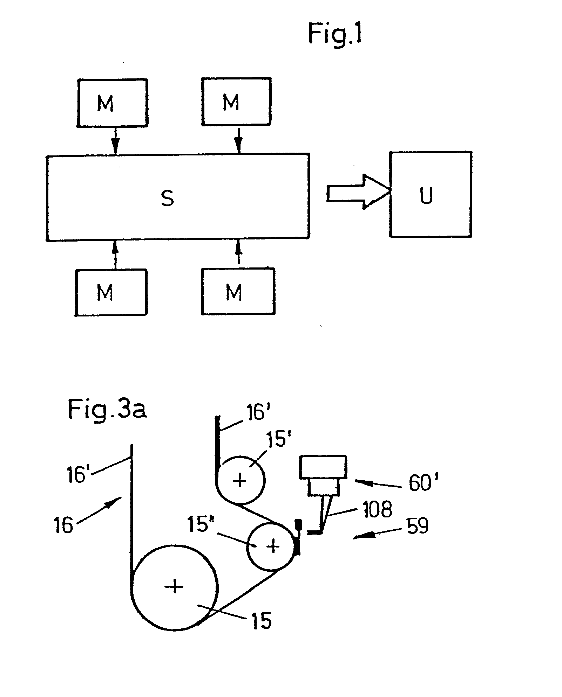

In der Fig. 1 ist die erfindungsgemässe Einrichtung im Prinzip dargestellt. Sie besteht aus einer Einrichtung S zur Sequenzbildung der elektrischen Bauelemente und einer Einrichtung U zum Weiterverarbeiten dieser Bauelemente. In der Einrichtung S werden die Bauelemente, die dort in Magazinen M auf mehreren Gurten in radial gegurteter Form bereitstehen, wobei jeder Gurt eine Vielzahl von Bauelementen des gleichen Typs trägt, programmgesteuert abgerufen und in eine für die spätere Bestückung einer elektrischen Schaltung erforderlichen Sequenz gebracht. An der Übergabestation der Einrichtung S werden die Bauelemente in dieser Sequenz an die Einrichtung U übergeben.

Beispiel I

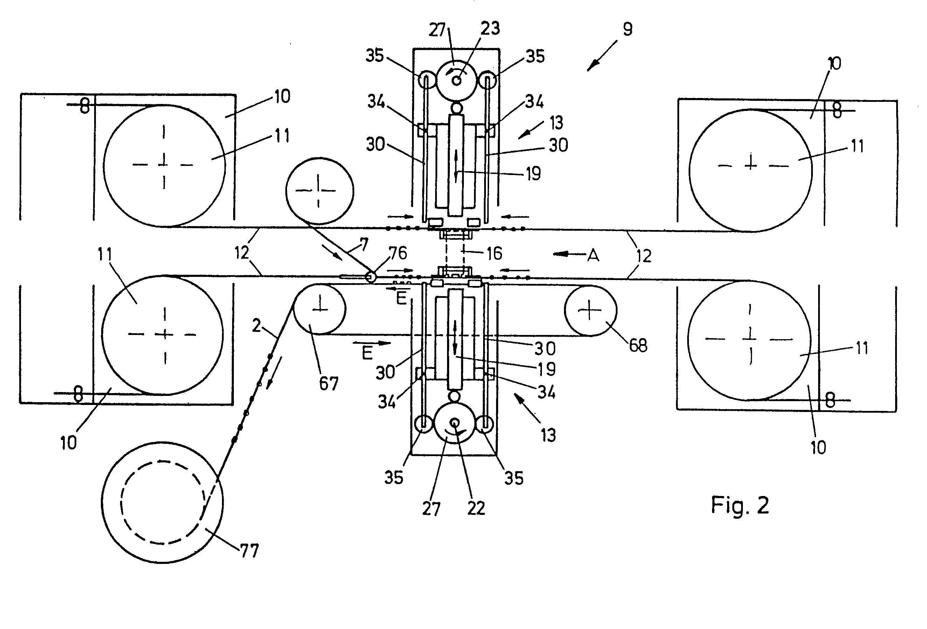

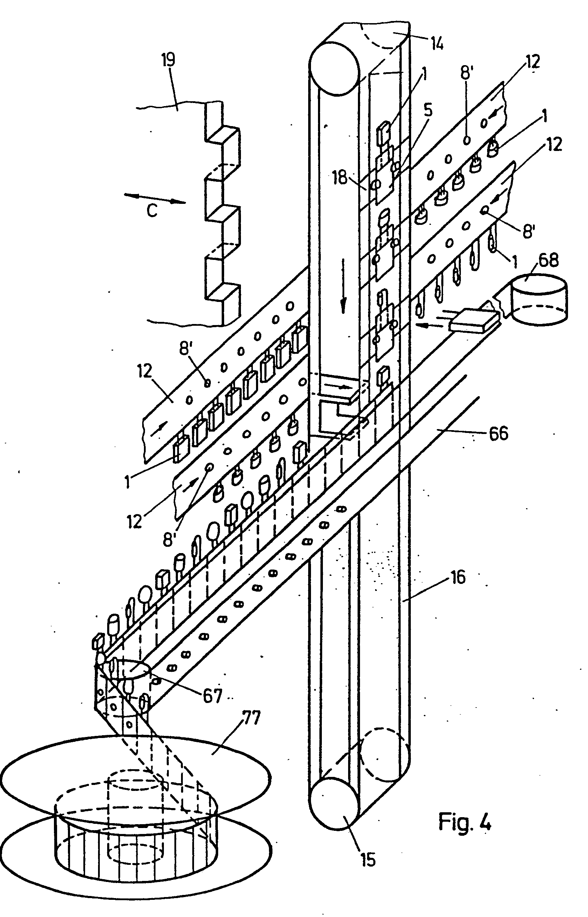

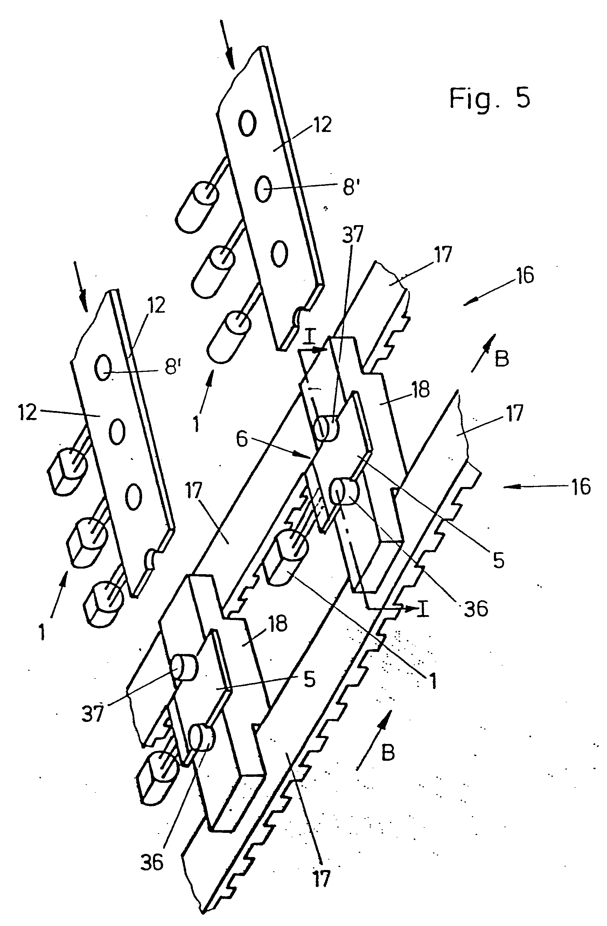

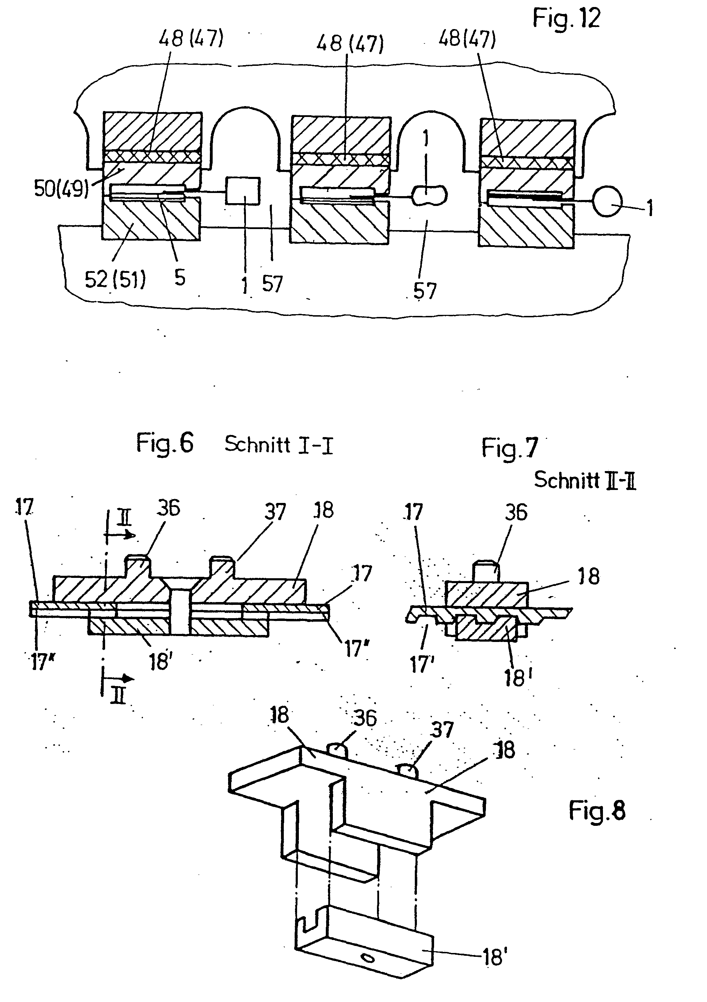

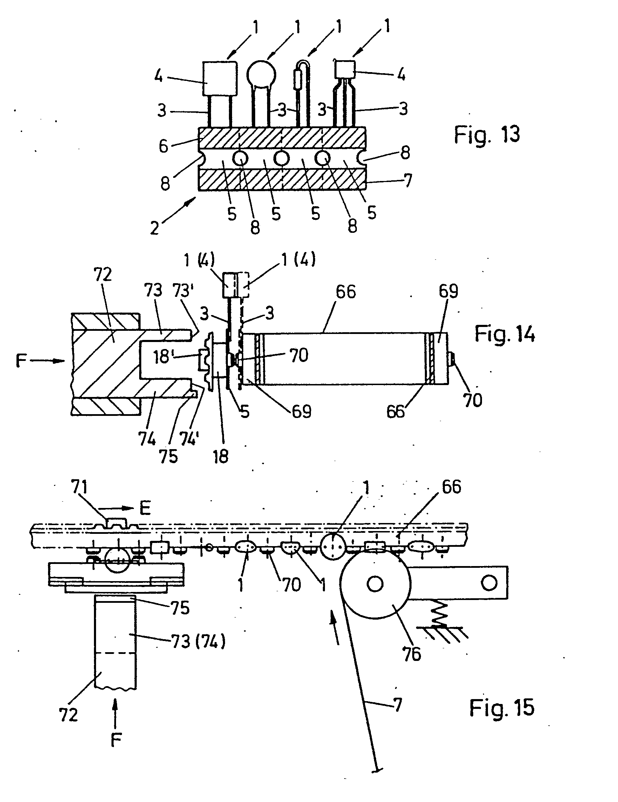

Bei der in den Fig. 2 bis 16 dargestellten Vorrichtung 9 ist die Einrichtung U als Einrichtung zum erneuten Aufgurten der Bauelemente (Aufgurtstation 60) ausgebildet. Demnach werden mit dieser Ausführungsform entsprechend Fig. 13 elektrische Bauelemente 1 unterschiedlichen Typs erhalten, die in radial gegurteter Form auf einer gemeinsamen Gurtung 2 gehalten sind, und zwar in einer Sequenz, in der die Bauelemente 1 für die spätere Bestückung einer elektrischen Schaltung (z.B. Printplatte) in einem Bestückungsautomaten benötigt werden. Die Bauelemente stehen mit ihren Anschlussdrähten 3 und mit ihrem Bauelementekörper 4 in Richtung senkrecht zur Längserstreckung der Gurtung 2 von einer Längsseite dieser Gurtung weg. In der Fig. 13 ist das rechte Bauelement ein Transistor, das folgende Bauelement ein Widerstand, das folgende Bauelement ein Keramikkondensator und das linke Bauelement ein Elektrolyt-Kondensator.

Die Gurtung 2 ist von einzelnen Gurtabschnitten 5 gebildet, an denen jeweils mit Hilfe eines Klebestreifenabschnittes 6 ein Bauelement 1 gehalten ist und die durch einen, vorzugsweise jedoch durch zwei, jeweils an den Längsseiten der Gurtung 2 vorgesehene durchgehende Klebestreifen 7 miteinander verbunden sind. Die Gurtung 2 besitzt Perforationslöcher, die jeweils an den einander benachbarten Kanten der Gurtabschnitte 5 gebildet sind, und zwar dadurch, dass sich jeweils zwei an diesen Kanten vorgesehene seitliche Ausnehmungen bzw. Laibungen 8 zu einem Perforationsloch ergänzen. Nachfolgend wird zunächst die Einrichtung S zur Sequenzbildung beschrieben.

Einrichtung zur Sequenzbildung:

Diese Einrichtung weist mehrere Magazine auf, die mit 10 bezeichnet sind und von denen jedes zur Aufnahme eines zu einer Spule 11 aufgewickelten Gurtes 12 dienen, an welchem jeweils gleichartige Bauelemente 1 in radial gegurteter Form mit Hilfe des Klebstreifens 6 gehalten sind und welcher Perforationslöcher 8' aufweist.

Die Magazine 10 sind in horizontalen Ebenen (Magazinebenen) säulenartig übereinander angeordnet, wobei in jeder Magazinebene vier Magazine 10 vorgesehen sind, und zwar bei der für die Fig. 2 gewählten Darstellung in jeder Magazinebene zwei Magazine 10 auf der linken Seite und zwei Magazine 10 auf der rechten Seite eines sich in vertikaler Richtung erstreckenden Maschinenrahmens 13. In jeder Magazinebene sind die Magazine 10 auf jeder Seite des Rahmens 13 spiegelbildlich zueinander angeordnet. Gleichzeitig liegen auch die Magazine 10 auf verschiedenen Seiten des Maschinenrahmens 13 (bezüglich des Maschinenrahmens 13) spiegelbildlich zueinander. Durch diese spiegelbildliche Anordnung wird erreicht, dass Einlauf und Lage der Bauelemente in die Vorrichtung bzw. Maschine identisch sind.

Im mittleren Teil des Maschinenrahmens 13 sind am oberen und am unteren Ende zwei zahnriemenradartig ausgebildete Umlenkwalzen 14 und 15 drehbar gelagert, und zwar jeweils um eine horizontale Achse, wobei wenigstens eine Umlenkwalze, beispielsweise die Umlenkwalze 15 durch einen nicht näher dargestellten Antriebsmotor, z.B. Schrittmotor oder Gleichstrommotor mit Positionssteuerung getaktet angetrieben wird. Über die Umlenkwalzen 15 ist ein bandförmiges, in sich geschlossenes erstes Transportelement 16 geführt, welches aufgrund der Anordnung der Umlenkwalzen 14 und 15 zwei sich in vertikaler Richtung und im Abstand voneinander angeordnete Längen 16' aufweist und welches aufgrund des Antriebs der Umlenkwalze 15 ebenfalls getaktet umläuft, und zwar normalerweise in einer Richtung entsprechend den Pfeilen B.

Das Transportelement 16 besteht aus zwei parallel zueinander und im Abstand voneinander angeordneten Zahnriemen 17, die über eine Vielzahl, jeweils in einem gleichförmigen Abstand voneinander angeordneten und mit ihrer Längserstreckung senkrecht zur Bewegungsrichtung des Transportelementes 16 liegenden Stegen 18 (Aufnahmen) miteinander verbunden sind.

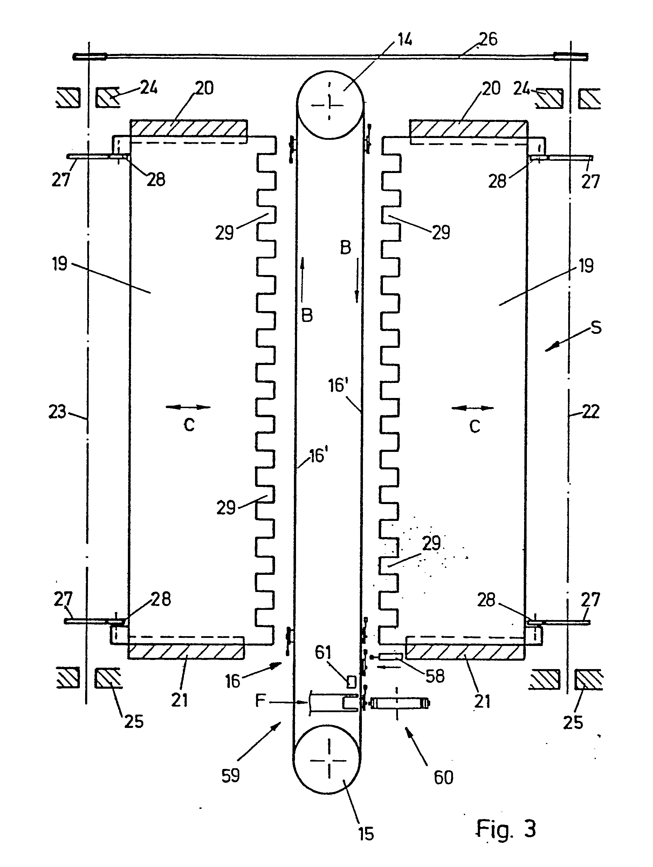

Seitlich von jeder vertikalen Länge 16' des Transportelementes 16 ist ein sich in Bewegungsrichtung des Transportelementes, d.h. bei der dargestellten Ausführung ebenfalls in vertikaler Richtung erstreckender langer Messer- oder Schneidbalken 19 vorgesehen, welcher dazu dient, einzelne, an das Transportelement 16 zu übergebende Gurtabschnitte 5 (jeweils mit zugehörigen Bauelement 1) von den in den Magazinen 10 bereit stehenden Gurtbändern 12 abzuschneiden, und zwar in der Mittelachse der Perforation (Perforationslöcher 8'). Jeder Schneidbalken 19 ist an seinem oberen sowie an seinem unteren Ende in einer horizontalen Führung 20 bzw. 21 derart verschiebbar geführt, dass er in Richtung senkrecht zur Achse der Umlenkwalzen 14 und 15 eine den Doppelpfeilen C entsprechende hin- und hergehende Bewegung auf das Transportelement 16 zu und von diesen wieder weg ausführen kann. Zum Antrieb der beiden Schneidbalken 19 dienen zwei vertikale Haupt- oder Meisterwellen 22 und 23, die am oberen Ende bei 24 und am unteren Ende bei 25 am Maschinenrahmen 13 drehbar gelagert sind und jeweils an der dem Transportelement 16 entfernt liegenden Seite des zugehörigen Schneidbalkens 19 angeordnet sind. Die beiden Wellen 22 und 23 sind am oberen Ende mit Hilfe eines Ketten- oder Riementriebs 26 antriebsmässig miteinander sowie mit einem nicht dargestellten Antriebselement (Motor) verbunden. Die Wellen 22 und 23 tragen im Bereich ihrer oberen und unteren Lagerung 24 bzw. 25 jeweils eine Kurven- bzw. Exzenterscheibe 27, die gegen eine Rolle 28 am oberen bzw. am unteren Ende des zugehörigen Schneidbalkens 19 anliegt. Durch die Kurvenscheiben 27 werden die Schneidbalken 19 in der oben beschriebenen Weise in Richtung der Doppelpfeile C hin- und herbewegt, wobei die Rückstellung der Schneidbalken 19 in ihrer in der Fig. 3 dargestellten Ausgangslage durch nicht dargestellte Federmittel erfolgen kann. Grundsätzlich ist es auch möglich, die Kurvenscheiben 27 so auszubilden, dass eine Zwangsführung der Schneidbalken 19 erfolgt, ohne dass Federmittel zur Rückstellung erforderlich sind.

An ihrer dem Transportelement 16 zugewendeten Seite sind die Schneidbalken 19 mit einer Vielzahl von Schneidmesser 29 versehen, von denen jeweils zwei in der Zeichenebene dieser Fig. 3 hintereinanderliegen und ein Schneidmesserpaar bilden. Die Anordnung ist weiterhin so getroffen, dass jedem Schneidmesserpaar an einem Schneidbalken 19 ein Schneidmesserpaar am anderen Schneidbalken 19 niveaugleich gegenüberliegt, wobei die einander gegenüberliegenden Schneidmesserpaare jeweils auf dem gleichen horizontalen Niveau mit einer Magazinebene liegen. Jedes Schneidmesserpaar definiert eine Ladeposition der Vorrichtung.

Seitlich von den beiden vertikalen Längen des Transportelementes 16 und beidseitig von jedem Schneidbalken 19 sind am Maschinengestell 13 jeweils um eine sich in Bewegungsrichtung des Transportelementes 16 erstreckende, d.h. bei der dargestellten Ausführung um eine vertikale Achse zwei Wippen 30 schwenkbar gehaltert, wobei jede Wippe 30 sich über die gesamte Länge des Schneidbalkens 19 erstreckt und an ihrem dem Transportelement 16 zugewendeten Ende eine Vielzahl von Druckluftzylindern 31 in der Form trägt, dass jeder Druckluftzylinder 31 in Richtung senkrecht zur Bewegungsrichtung des Förderelementes 16 seitlich von einem Schneidmesser 29 angeordnet ist. Jeder Druckluftzylinder 31, der jeweils einem Magazin 10 zugeordnet ist und über wenigstens eine Druckluftsteuerleitung 32 mit einer nicht näher dargestellten Druckluftsteuereinrichtung in Verbindung steht, weist einen in dem Zylinder verschiebbar geführten Kolben auf, dessen Kolbenstange über das eine Ende des Druckluftzylinders 31 vorsteht und mit diesem vorstehenden Ende einen Stössel bzw. Mitnahmestift 33 bildet, der zum Vorschub eines Gurtes 12 in ein Perforationsloch 8' dieses Gurtes eingreifen kann, wenn der betreffende Zylinder 31 mit Druckluft beaufschlagt wird. Beispielsweise durch eine Feder wird der Mitnahmestift 33 in eine Stellung zurückgeführt, in der er ausser Eingriff mit den Perforationslöchern 8' ist. Selbstverständlich kann durch die Verwendung von zwei Steuerleitungen 32 an jedem Druckluftzylinder 31 sowie durch entsprechende Ausbildung dieses Druckluftzylinders die Steuerung des Mitnahmestiftes 33 allein durch Druckluft erfolgen.

Das Schwenken der Wippen 30 um ihre vertikale Schwenkachse 34 erfolgt bei der dargestellten Ausführung dadurch, dass die Wippen mit ihrem dem Transportelement 16 abgewendeten Ende bzw. mit dort vorgesehenen Rollen 35 (bei entsprechender Ausbildung der Kurvenscheiben 27) ebenfalls gegen diese Kurvenscheiben 27 durch ein nicht näher dargestelltes Rückstellfederelement angepresst anliegen, oder aber dadurch, dass die Rollen 35 mit zusätzlichen, an den Wellen 22 und 23 vorgesehenen Kurvenscheiben zusammenwirken. Immer dann, wenn die Wippen 30 sich mit ihren dem Transportelement 16 zugewendeten Ende in Richtung auf den zwischen zwei Wippen vorgesehenen Schneidbalken 19 zubewegen bzw. schwenken, werden diejenigen Gurtbänder 12, in deren Perforation 8' durch vorheriges Betätigen des zugehörigen Druckzylinders 31 der zugehörige Mitnahmestift 33 eingegriffen hat, zusammen mit dem ersten, bereitstehenden Bauelement 1 gleichzeitig um die Länge eines Gurtabschnittes 5 (eine Teilung) vorgeschoben, worauf dann die Schneidbalken 19 sich auf das Transportelement 16 zubewegen und von allen vorgeschobenen Gurten 12 den jeweiligen Gurtabschnitt 5 mit dem zugehörigen Bauelement 1 gleichzeitig abschneiden und diesen Gurtabschnitt an das Transportelement 16 andrücken, und zwar an jeweils einen bereit stehenden Steg 18 dieses Transportelementes. Es versteht sich, dass die Bewegungen des Transportelementes 16, der Wippen 30 sowie der Schneidbalken 19 so aufeinander abgestimmt bzw. so miteinander synchronisiert sind, dass zumindest das Abschneiden der Gurtbandabschnitte 5 sowie das Andrücken dieser Abschnitte an das Transportelement 16 jeweils bei stillstehendem Transportelement 16 erfolgen. Durch entsprechende Steuerung der Druckluftzylinder 31 nach einem vorgegebenen Programm in Abhängigkeit von der jeweiligen Lage des Transportelementes 16 wird erreicht, dass am Transportelement 16 in Umlaufrichtung dieses Transportelementes die unterschiedlichen Bauelemente 1 aus den verschiedenen Magazinen 10 bereits in der für die Weiterverarbeitung bzw. spätere Gurtung 2 erforderliche Sequenz angeordnet sind.

Die zur Aufnahme und Halterung jeweils eines Gurtabschnittes 5 dienenden Stege 18 weisen in Umlaufrichtung des Transportelementes 16 einen Abstand voneinander auf, der durch den Abstand zweier hintereinander liegender Bauelemente 1 mit Gurtabschnitt 5 am Transportelement 16 bestimmt ist, der jedoch auch dem Abstand zweier Schneidmesser 29 in Längsrichtung des Schneidbalkens 19 und damit dem Abstand entspricht, den zwei benachbarte, jeweils vier Magazin 10 aufweisende Magazinebenen voneinander besitzen. Jeder Steg 18 weist zwei zylinderische Zapfen 36 und 37 auf, die senkrecht zur Förderrichtung des Transportelementes 16 von den Stegen 18 wegstehen und die in Teilaussparung bzw. halbe Perforationslöcher 8' (Laibungen) des abgeschnittenen Gurtabschnittes 5 eingreifen. Dadurch wird jeder Gurtabschnitt 5 zusammen mit dem daran gehaltenen Bauelement 1 auf dem betreffenden Steg 18 exakt positioniert und durch Klemmsitz gehalten. Da die einzelnen Gurtbänder 12 aus den Magazinen 10 hochkant stehend in horizontaler Richtung an das Transportelement 16 bzw. an die jeweilige Ladeposition (durch die Wippen 30 und Mitnahmestifte 33 an den Druckluftzylinder 31) gefördert werden, ist jedes Bauelement 1 an dem betreffenden Steg 18 so fest gelegt, dass die Anschlussdrähte 3 in Förderrichtung des Transportelements 16 liegen, und zwar vorzugsweise derart, dass (bezogen auf die normale Förderrichtung des Transportelements 16) der jeweilige Gurtabschnitt 5 voreilend und das zugehörige Bauelement 1 bzw. dessen Bauelementkörper 4 nacheilend am Steg 18 festgelegt sind. Der Bauelementkörper 4 jedes Bauelementes 1 ist dabei in einem Freiraum zwischen zwei benachbarten Stegen 18 angeordnet, während die Anschlussdrähte 3 an den Gurtabschnitten 5 mit Hilfe des Klebstreifenabschnittes 6 gehalten sind. Die Stege 18 haben auf der innen liegenden Seite des Transportelementes 16 Laschen mit Nuten (Nutensteinen 18'), welche in die Verzahnung der beiden Zahnriemen 17 eingreifen und somit räumlich einwandfrei festgelegt sind. Die freien Randbereiche 17'' dienen zum Eingriff in die Doppelverzahnung der Umlenkwalzen 14 und 15 sowie gegebenenfalls zum Führen der Zahnriemen 17 über Umlenkrollen 15' und 15'' (Fig. 3a).

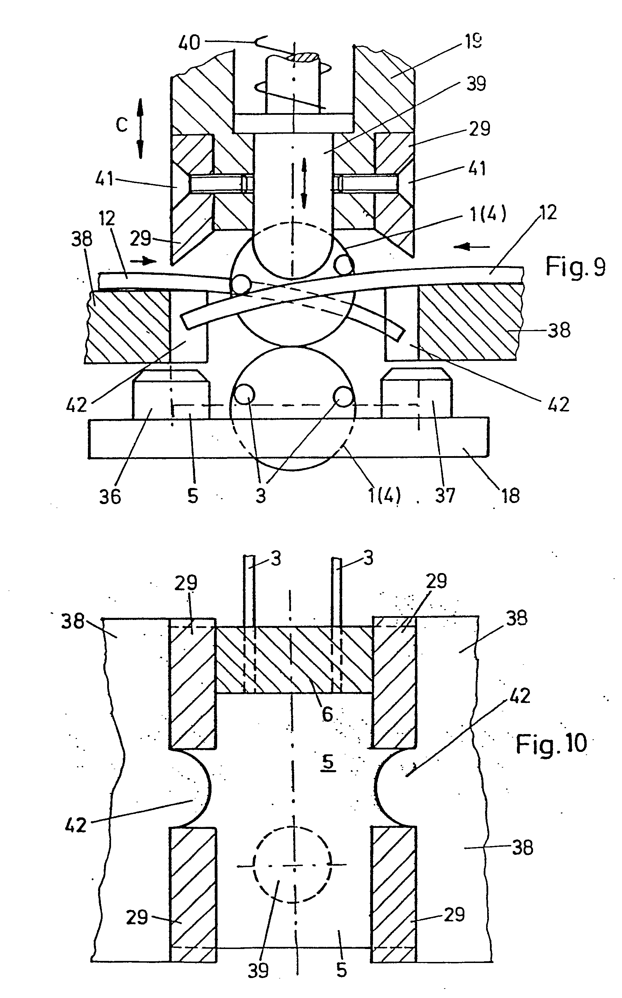

Die Ausgestaltung der die Schneidbalken 19 aufweisenden Schneidvorrichtungen bzw. Ladepositionen ist in den Fig. 9–12 im einzelnen dargestellt. Die an den Schneidbalken 19 vorgesehenen beweglichen Schneidmesser 29 arbeiten mit starren bzw. ortsfesten Schneidmessern 38 zusammen. An den Schneidbalken 19 ist jedem von zwei Schneidmessern 29 gebildeten Schneidmesserpaar ein balliger, federnder Niederhalter 39 zugeordnet, der von der Seite her gegen den zugehörigen Gurt 12 drückt und das freie vordere Ende dieses Gurtes leicht zur Seite d.h. in Richtung auf das Transportelement 16 biegt (wie in der Fig. 9 dargestellt), bevor der Schneidvorgang beginnt, damit das vordere freie Ende des Gurtes 12 mit dem zugehörigen Bauelement 1 in dem Raum zwischen den beiden starren Schneidmessern 38 geführt wird und nicht ausweichen kann.

Der ballige Niederhalter 39 steht unter der Vorspannung einer Feder 40. Die beweglichen Schneidmesser 29 sind mittels Schrauben 41 an den Messer- bzw. Schneidbalken 19 befestigt. Jeder Schneidbalken 19 führt nach Beendigung des Schneidvorganges eine weitere Bewegung in Richtung auf das Transportelement 16 zu aus und drückt dadurch den von einem Gurt 12 abgeschnittenen Gurtabschnitt 5 in die in der Fig. 9 mit unterbrochenen Linien angegebene Position in Anlage auf den bereitstehenden Steg 18 zum Weitertransport auf dem Transportelement 16. Jedes Schneidmesser 38 besitzt in seinem mittleren Bereich einen halbkreisförmigen Vorsprung 42. Diese Vorsprünge 42 liegen während des Schneidvorganges sowie während der Übergabe des abgeschnittenen Gurtabschnittes 5 deckungsgleich mit jeweils einem Zapfen 36 bzw. 37, so dass nicht nur während des Schneidvorganges das mit der vordersten Teilaussparung bzw. Laibung 8 an einem Vorsprung 42 eingreifende Gurt 12 gegen Verrutschen gesichert ist, sondern sich auch während der Übergabe des abgeschnittenen Gurtabschnittes 5 an den bereitstehenden Steg 18 eine einwandfreie Führung und Halterung für diesen Gurtabschnitt ergibt.

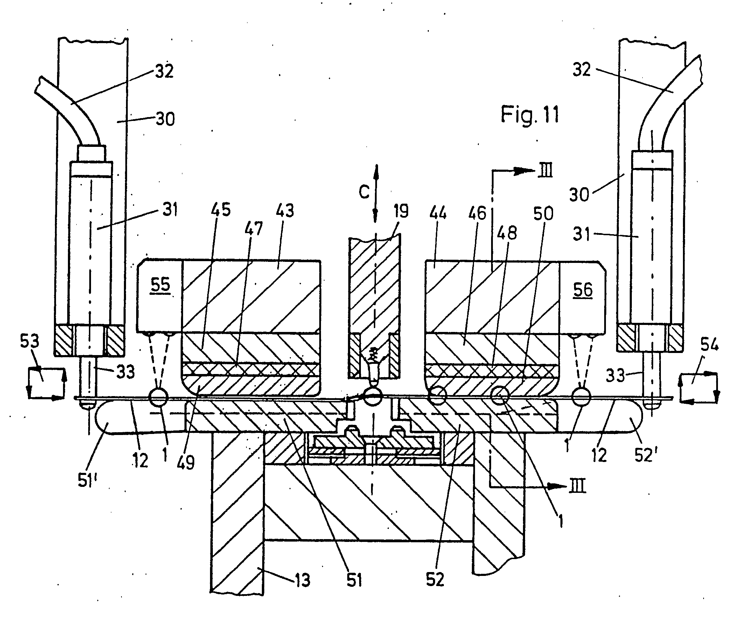

In der Fig. 11 sind der Aufbau und die Funktion der Wippe 30 mit zusätzlicher Brems- oder Halteeinrichtung für die Enden der Gurtbänder 12 näher dargestellt. Wie oben bereits erwähnt wurde, wird immer dann, wenn ein jedem Magazin 10 zugeordneter Druckluftzylinder 31 betätigt wurde, das betreffende Gurt 12 dieses Magazins um einen Schritt (Länge eines Gurtabschnittes 5) weitergeschoben bzw. in den Bereich der Schneidvorrichtung geschoben wird, wenn die beidseitig von einem Schneidbalken 19 angeordneten Wippen 30 sich aufeinander bzw. auf den Schneidbalken 19 zubewegen. Wird ein bestimmter Druckluftzylinder 31 nicht betätigt, so erfolgt trotz des Schwenkens der Wippen 30 kein Weiterbewegen des zugehörigen Gurtes 12. Mit den Gurtbändern 12 und deren Auflagen wirken an Haltebalken 43 und 44 der Maschine befestigte Bremsvorrichtungen in Form von Bremsblöcken 45 und 46 zusammen, die Gummilagen 47 und 48 aufweisen, wobei der jeweils als Anlagefläche für ein Gurt 12 dienende Teil 49 und 50 aus verschleissfestem Material hergestellt ist. Mit 51 und 52 ist jeweils eine starre Gegenauflage bezeichnet, die beispielsweise von jeweils einem Teil des starren Messers 38 gebildet ist. Jedes Gurt 12 ist mit seinem freien Ende in dem Spalt zwischen einer Gegenauflage 51 bzw. 52 und einem Bremsblock 45 bzw. 46 gehalten, so dass die freien Enden der Gurtbänder 12 auch dann nicht verlorengehen können, wenn die Mitnahmestifte 33 nicht mit den Perforationslöcher 8' dieser Gurtbänder in Eingriff stehen.

Mit 53 und 54 ist schematisch der Bewegungsverlauf der Mitnahmestifte 33 während des Gurtvorschubes dargestellt.

An den Haltebalken 43 und 44 sind Fotozellen oder entsprechende Überwachungselemente 55 bzw. 56 vorgesehen, die das einwandfreie Vorhandensein der Bauelemente 1 auf dem jeweiligen Gurt 12 beim Einlauf prüfen, d.h. feststellen, ob die Bauelemente 1 und deren Anschlussdrähte 3 vorhanden und richtig positioniert sind.

Innerhalb der Bremsvorrichtungen sind zwischen den Teilen 49 und 51 bzw. 50 und 52 Aussparungen 57 gebildet, die jeweils ein Bauelement 1 aufnehmen. Die Gegenauflagen 51 bzw. 52 besitzen jeweils einen Ansatz 51' bzw. 52', der gabelförmig mit einem zum freien Ende des Ansatzes hin offenen Schlitz ausgebildet ist, in dem sich der Mitnehmer 33 beim Vorschub des Gurtes 12 bewegt.

In Normalförderrichtung (Pfeil B) des Transportelementes 16 vor der Übergabestation 59 ist am Transportelement 16 ortsfest eine Messvorrichtung 58 vorgesehen, die alle am Transportelement 16 gehaltenen Bauelemente auf Vorhandensein, Qualität, mechanische Beschaffenheit sowie Type prüft, bevor diese Bauelemente durch das Transportelement 16 an eine Übergabestation 59 und von dieser an eine Aufgurtstation 60 transportiert werden. Mit der Messvorrichtung 58 kann gleichzeitig auch überprüft werden, ob die Bauelemente 1 am Transportelement 16 tatsächlich in der geforderten Sequenz aufeinanderfolgend gehalten sind.

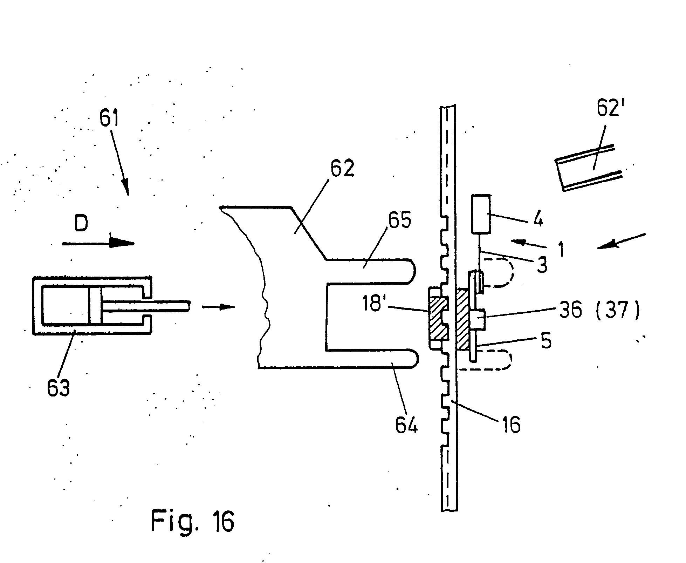

Stellt die Messvorrichtung 58 beispielsweise fest, dass ein bestimmtes Bauelement fehlerhaft ist oder aber nicht der geforderten Type oder Art entspricht, so wird dieses Bauelement mit Hilfe einer der Messvorrichtung 58 in Bewegungsrichtung des Transportelementes 16 nachfolgenden, ebenfalls ortsfesten Abstreifvorrichtung 61 ausgeworfen. Eine Ausführungsform dieser Abstreifvorrichtung 61 ist in der Fig. 16 dargestellt. Bei einer fehlerhaften und/oder nicht der geforderten Type bzw. Art entsprechenden Bauelement 1 wird von der Messvorrichtung 58 ein entsprechendes Signal an die Abstreifvorrichtung 61 geliefert, die das fehlerhafte oder falsche Bauelement 1 von dem betreffenden Steg 18 des Transportelementes 16 entfernt. Wie die Fig. 16 zeigt, besitzt die Abstreifvorrichtung 61 hierfür einen in horizontaler Richtung (Pfeil D) verschiebbaren Ausstosser 62, der aufgrund des von der Messvorrichtung 58 gelieferten Signales von einem pneumatischen Kolben 63 betätigt wird und an seinem dem Transportelement 16 zugewendeten Ende zwei im Abstand voneinander angeordnete Arme 64 und 65 aufweist, die beim Betätigen des Zylinders 63 den das fehlerhafte bzw. falsche Bauelement aufweisenden Steg 18 gabelförmig übergreifen und den Gurtabschnitt 5 zusammen mit diesem Bauelement seitlich ausstossen. Erstreckt sich das Transportelement mit seinen Längen 16' in horizontaler Richtung, so kann zusätzlich eine Luftdüse 62' zum Abblasen des fehlerhaften Bauelementes 1 vorgesehen sein. Nach dem Ausstossen eines fehlerhaften oder falschen Bauelementes 1 wird automatisch ein Reparierprogramm eingeleitet, und zwar in der Form, dass nach Unterbrechung der Übergabe der Bauelemente 1 an die Aufgurtstation 60 der vorher mit dem falschen oder fehlerhaften Bauelement 1 bewegte Steg 18 durch Vorwärts- oder Rückwärtsbewegung des Transportelementes 16 an die dem erforderlichen Bauelement 1 entsprechende Ladeposition bewegt und dort mit einem neuen Bauelement 1 der geforderten Art und Type versehen wird. Anschliessend nimmt das Transportelement 16 wieder die Stellung ein, die es vor der Einleitung des Reparierprogrammes aufwies, so dass dann die Übergabe der Bauelemente an die Aufgurtstation 60 fortgesetzt werden kann. Die beschriebene Einrichtung zur Sequenzbildung wird (mit evtl. geringen Änderungen) auch bei anderen, später noch beschriebenen Ausführungen verwendet. Anschliessend wird die Einrichtung zu Weiterverarbeitung, die bei der Vorrichtung 9 als Aufgurtstation ausgebildet ist, zusammen mit der Übergabestation 59 an den Fig. 14 und 15 beschrieben.

Aufgurtstation:

Im Bereich der Übergabestation 59 ist am Transportelement 16 ist ein weiteres (zweites) Transportelement 66 unmittelbar vorbeigeführt. Dieses zweite, ebenfalls band- oder riemenförmige, in sich geschlossene Transportelement 66, welches unterhalb der beiden Schneidbalken 19 angeordnet ist, läuft über zwei Umlenkrollen oder Scheiben 67 und 68 um, von denen eine, beispielsweise die Umlenkrolle 68 getaktet und synchron zur Bewegung des Transportelementes 16 angetrieben ist. Das Transportelement 66 ist ebenfalls von einem Zahnriemen gebildet, wobei dann auch die Umlenkrollen 67 und 68 Zahnriemenräder sind. Die Achsen der Umlenkrollen 67 und 68 liegen parallel zueinander und erstrecken sich in vertikaler Richtung, so dass das Transportelement 66 getaktet (in Richtung des Pfeiles E) in horizontaler Richtung umläuft, d.h. in einer Richtung, die senkrecht zur Bewegungsrichtung des Transportelementes 16 ist.

Das Transportelement 66 trägt an seiner Aussenseite eine Vielzahl von Klötzen oder Aufnahmen 69, die an ihrer vertikalen Aussenfläche zapfenartige Vorsprünge 70 aufweisen. Diese Vorsprünge liegen mit ihrer Achse senkrecht zur Bewegungsrichtung (Pfeil E) des Transportelementes 66 und sind in gleichmässigen Abständen in Bewegungsrichtung (Pfeil E) des Transportelementes 66 derart vorgesehen, dass der Abstand zwischen zwei benachbarten Zapfen 70 gleich dem Abstand ist, den die beiden Zapfen 36 und 37 an jedem Steg 18 voneinander aufweisen. Bei der dargestellten Ausführungsform besitzt jeder Klotz 69 in seiner Mitte einen einzigen Zapfen 70, so dass jeweils zwischen den Zapfen 70 zweier benachbarter Klötze 69 eine Aufnahme gebildet ist. Die Anordnung und Steuerung des Transportelementes 66 sind weiterhin so getroffen, dass eine zwischen den Umlenkrollen 67 und 68 gebildete Länge des Transportelementes 66 der Aussenfläche des Transportelementes 16 unterhalb der Messvorrichtung 58 und der Abstreifvorrichtung 61 unmittelbar gegenüber liegt, und zwar derart, dass in jeder Stillstandsphase des Transportelementes 16 die beiden Zapfen 36 und 37 einer Aufnahme bzw. eines Steges 18 zwei benachbarten Zapfen 70 unmittelbar gegenüberliegen bzw. sich die Zapfen 70 und die Zapfen 36 bzw. 37 an ihren freien Enden berühren oder nahezu berühren, in jedem Fall jedoch die Zapfen 36 und 37 eines Steges 18 ihre Fortsetzung in zwei benachbarten Zapfen 70 des Transportelementes 66 finden. Die einzelnen Klötze 69 sind an dem das Transportelement 66 bildenden Zahnriemen beispielsweise wiederum mit Nutensteinen 71 (ähnlich den Nutensteinen 18') gehalten.

Die Übergabestation 59 besteht im wesentlichen aus einem Ausstosser 72, der ähnlich dem Ausstosser 62 an der Innenseite des Transportelementes 16, d.h. an der den Zapfen 36 und 37 der Stege 18 abgewendeten Seite dieses Transportelementes angeordnet ist. Der Ausstosser 72 kann durch ein nicht näher dargestelltes Antriebselement (z.B. pneumatischen Zylinder) in horizontaler Richtung (Pfeil F) betätigt werden. Der Ausstosser 72 besitzt an seinem dem Transportelement 16 zugewendeten Ende zwei Arme 73 und 74, die ähnlich den Armen 64 und 65 des Ausstossers 62 in einer vertikalen Ebene übereinander liegen. Die Arme 73 und 74 bilden in einer gemeinsamen vertikalen Ebene liegende Ausstoss- bzw. Anlageflächen 73' und 74', wobei der Arm 74 an seiner dem Arm 73 abgewendeten Seite an dieser Fläche noch einen über die Fläche vorstehenden leistenförmigen Vorsprung 75 aufweist, der mit seiner Oberseite eine zusätzliche Anlage- bzw. Abstützfläche für jeden vom Transportelement 16 auf das Transportelement 66 zu übertragenden Gurtabschnitt 5 bildet. Die Fig. 14 und 15 zeigen den Ausstosser 72 in seiner Ruhestellung bzw. zurückgeschobenen Stellung. Hat ein Steg 18 die Übergabestation 59 erreicht, so wird in der Stillstandsphase der beiden Transportelemente 16 und 66 der Ausstosser 72 in Richtung des Pfeiles F bewegt, wodurch die beiden Arme 73 und 74 in den Raum zwischen den beiden Zahnriemen 17 des Transportelementes 16 eintreten und den betreffenden Steg 18 oben und unten übergreifen. Die Flächen 73' und 74' kommen dabei gegen den Gurtabschnitt 5 zur Anlage, der geringfügig über die Oberseite und Unterseite des Steges 18 vorsteht. Beim weiteren Verschieben des Ausstossers 72 in Richtung des Pfeiles F wird der Gurtabschnitt 5 mit dem an ihm gehaltenen und von diesem nach oben wegstehenden Bauelement 1 von den Zapfen 36 und 37 auf zwei diesem unmittelbar gegenüberstehende, einander benachbarte Zapfen 70 des Transportelementes 66 aufgeschoben, wobei der Vorsprung 75 in der oben erwähnten Weise eine zusätzliche untere Abstützfläche für den Gurtabschnitt 5 bildet. Nach dem endgültigen Aufschieben des Gurtabschnittes 5 auf zwei benachbarte Zapfen 70 des Transportelementes 66 ist der Gurtabschnitt 5 dort wiederum durch Klemmsitz gehalten. Nach der Rückkehr des Ausstossers 72 in seine Ausgangsstellung, in der die Flächen 73' und 74' seitlich von der Innenseite des Transportelementes 16 liegen, führen die Transportelemente 16 und 66 einen weiteren Bewegungsschritt aus, und zwar bewegt sich das Transportelement 16 um eine Strecke weiter, die dem Abstand zweier Stege 18 entspricht, während das Transportelement 66 um eine Strecke weiterbewegt wird, die dem Abstand zweier Zapfen 70 entspricht. Nach dem erneuten Stillsetzen beider Transportelemente wird in der oben beschriebenen Weise ein weiterer Gurtabschnitt 5 mit einem weiteren Bauelement 1 an das Transportelement 66 übergeben, so dass dort schliesslich in unmittelbarer Folge aufeinander Gurtabschnitte 5 mit unterschiedlichen Bauelementen 1 (entsprechend der geforderten Sequenz) jeweils mit ihren Laibungen an den Zapfen 70 nebeneinander gehalten sind, und zwar derart, dass die Bauelemente 1 senkrecht zur Bewegungsrichtung (E) des Transportelementes 66 von diesem nach oben wegstehen. Die an den halben Perforationslöchern (Laibungen) an den Zapfen 70 und damit ausgerichtet am Transportelement 66 gehaltenen Gurtabschnitte 5 werden schliesslich an einer Rolle 76 vorbeigeführt, über die der durchgehende Klebestreifen 7 zugeführt wird und die gleichzeitig auch zum Anpressen dieses Klebestreifens an die einzelnen Gurtabschnitte 5 dient. Selbstverständlich können anstelle eines einzigen durchgehenden Klebestreifens 7 auch mehrere derartige Klebestreifen zugeführt werden, um beispielsweise in der oben beschriebenen Weise die Gurtabschnitte 5 sowohl an ihren oberen als auch an ihren unteren Längskanten zu der Gurtung 2 miteinander zu verbinden. Die durch den Klebestreifen 7 zu der Gurtung 2 miteinander verbundenen Gurtabschnitte 5 werden dann zusammen mit den daran befestigten Bauelementen 1 zu einer Spule 77 aufgewickelt. In Fig. 3a ist anstelle der Aufgurtstation 60 an der Übergabestation 59 ein Bestückungskopf 60' mit Bestückzange 108 dargestellt. In diesem Fall ist die Vorrichtung 9 ein Bestückautomat. Die eine Zange 16' ist dabei an der Übergabestation 59 vorzugsweise über Umlenkrollen 15' und 15'' schräg nach aussen geführt.

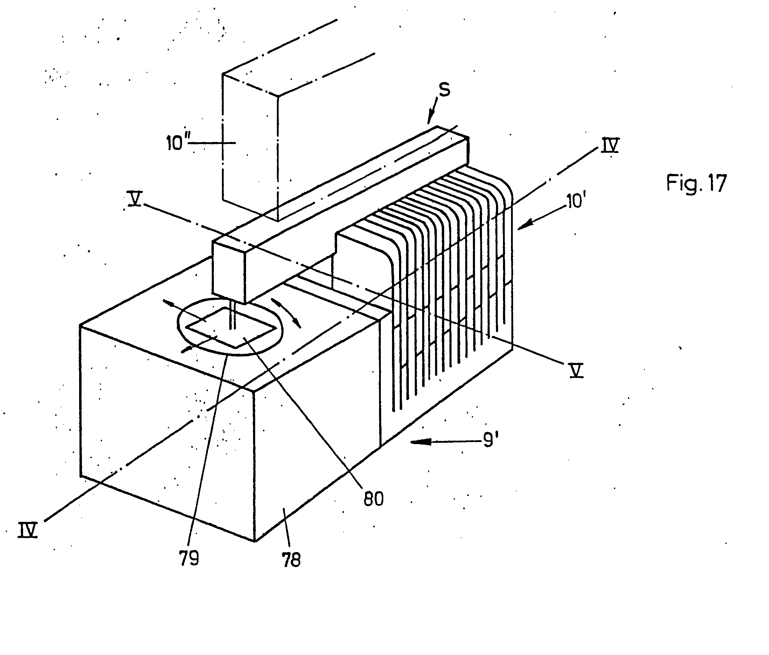

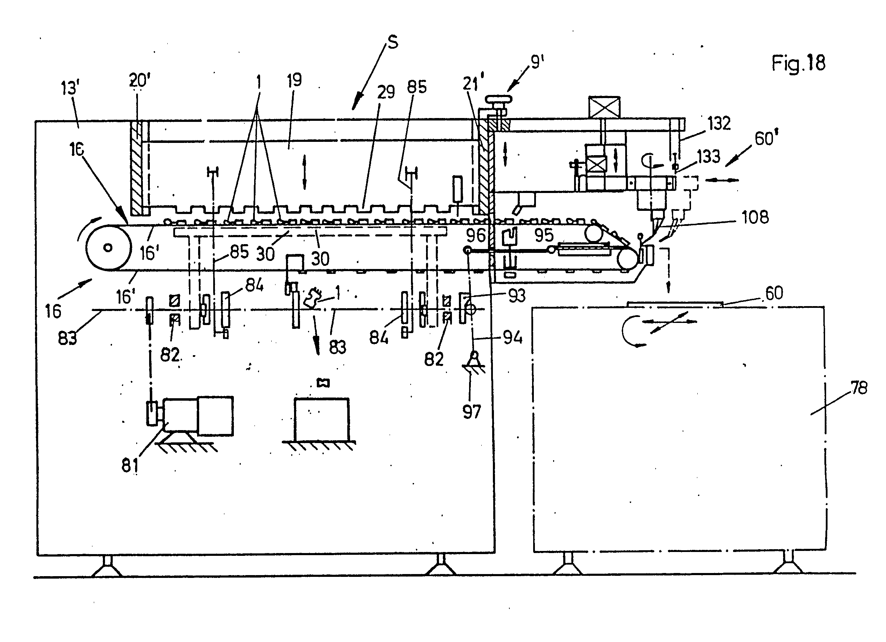

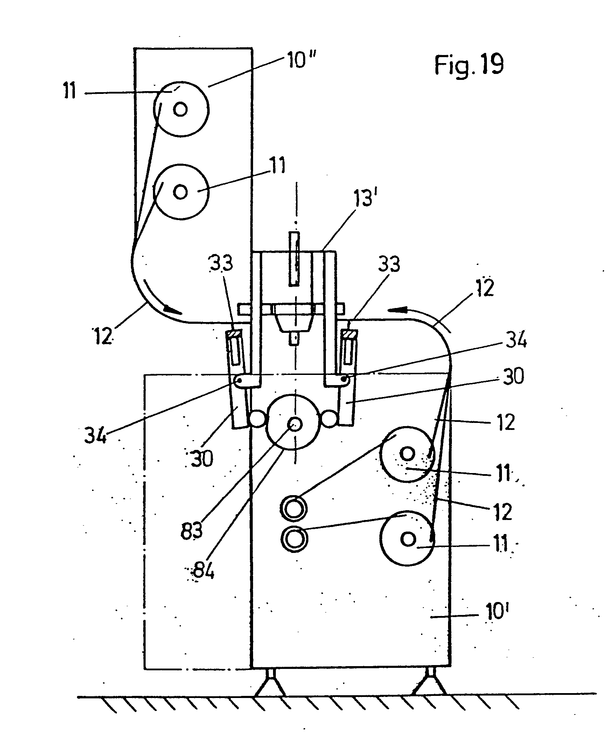

Eine weitere Vorrichtung 9' in Form eines Bestückungsautomaten ist in den Fig. 17 bis 31 dargestellt, in welchen für solche Elemente, die in ihrer Funktion Elementen der Vorrichtung 9' entsprechen, die gleichen Bezugsziffern wie in den Fig. 1 bis 16 verwendet sind.

Beispiel II

Die Vorrichtung 9' weist wiederum die Einrichtung S zur Sequenzbildung auf, die sich von der entsprechenden Einrichtung der Fig. 9 lediglich dadurch unterscheidet, dass die Fördereinrichtung 16 mit ihren Längen 16' in horizontaler Richtung derart angeordnet ist, dass die Längen 16' übereinander liegen. Anstelle von zwei Schneidbalken ist bei der Vorrichtung 9' lediglich ein einziger Schneidbalken 19 verwendet, der über der oberen Länge 16' angeordnet ist und beidendig in vertikalen Führungen 20' bzw. 21' am Maschinenrahmen 13' auf- und abbewegbar ist. Die Vorrichtung 9' weist auch nur zwei Wippen 30 auf, die um eine horizontale Achse schwenkbar sind.

Die Vorrichtung 9' weist entlang einer Längsseite des Transportelementes 16 Magazine 10' auf, in welchen jeweils zwei Spulen 11 übereinander angeordnet werden können. Bezogen auf die vertikale Mittelachse ist spiegelbildlich zu dem Magazin 10' ein weiteres Magazin 10'' vorgesehen. Die Bauelemente 1 werden in der oben beschriebenen Weise von den Gurten 12 programmgesteuert abgetrennt und an das Transportelement 16 übergeben. Die Einrichtung U zur Weiterverwendung der Bauelemente ist bei der Vorrichtung 9' eine Bestückungsstation mit einem X-Y-Tisch 78, der einen Drehteller 79 aufweist, auf dem eine zu bestückende Printplatte 80 festgelegt ist.

Zum Antrieb dient ein Antriebsmotor 81 (Schrittmotor oder Gleichstrommotor mit Positionssteuerung), der antriebsmässig mit dem im Inneren des Automaten unterhalb der Transporteinrichtung 16 drehbar in Lagern 82 gelagerten Haupt- oder Meisterwelle 83 verbunden ist. Auf der Welle 83 sitzen den Kurvenscheiben 27 entsprechende Kurvenscheiben 84, die mit an dem Schneidbalken 19 befestigten Zugstangen 85 zusammenwirken und den durch Federkraft angehobenen Schneidbalken 19 im Maschinenteil nach unten und oben antreiben. Auf der Welle 83 sitzen auch Kurvenscheiben 84' für die Wippen 30.

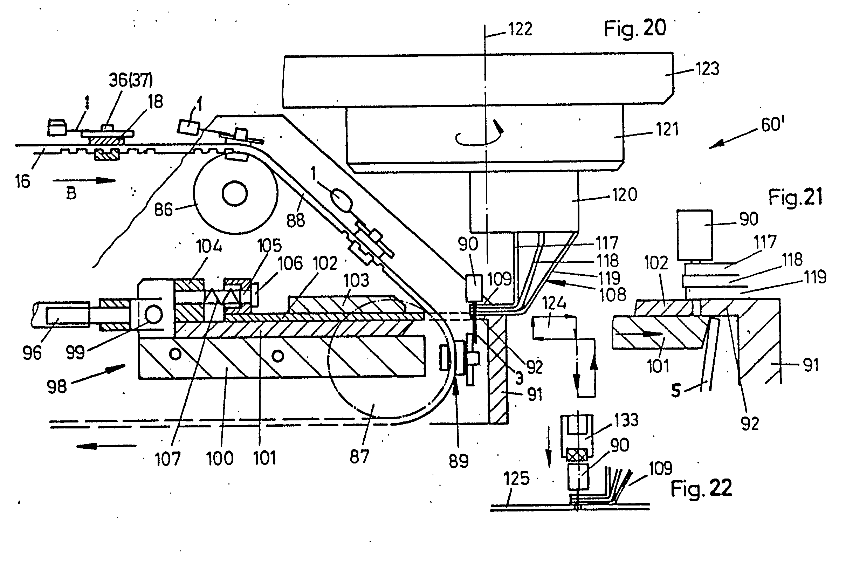

In Fig. 20 ist die Übergabe der einzelnen Bauelemente 9 auf eine Bestückzange 108 dargestellt, die einen wesentlichen Teil des Bestückungskopfes 60' bildet. Das Transportelement 16 weist bei dieser speziellen Ausgestaltung Umlenkrollen 86 und 87 auf, die so zueinander angeordnet und dimensioniert sind, dass ein Abschnitt 88 des Transportelementes 16 entsteht, der schräg nach vorne und unten verläuft, so dass ein Bauelement bei Erreichen der vordersten Stelle 89 der Umlenkrolle 87 eine vertikale Position einnimmt. Dieses Bauelement ist in Fig. 20 mit 90 bezeichnet. Ein horizontal wirkendes, den Anschlussdrähten 3 des Bauelementes 90 zugeordnetes starres Messer 91 stellt einen Schneidamboss dar, gegen dessen Ansatz 92 die Anschlussdrähte 3 des Bauelementes 90 beim Schwenken in die vertikale Position zur Anlage kommen. Die bewegliche Messervorrichtung 101 wirkt gegen das Bauelement 90 von der entgegengesetzten Seite (in bezug auf das starre Messer 91). Die Betätigung des beweglichen Messers erfolgt in der Weise, dass von einer auf der Hauptwelle 83 angeordneten Steuerkurve 93 aus ein Gestänge 94, 95 mit Gelenkstelle 96 und Gelenkbefestigung 97 am Maschinenrahmen eine Andrück-, Vorzentrier- und Schneidvorrichtung 98 programmgesteuert beaufschlagt, die über eine Gelenkverbindung 99 mit dem Gestängeteil 96 verbunden ist. Diese Andrück-, Vorzentrier- und Schneidvorrichtung 98 ist mit einem starren Träger 100 verbunden, auf dem ein bewegliches Schneidmesser 101 sowie ein Einspann- und Vorzentrierbauteil 102 befestigt ist, der einen beweglichen Gegendrücker gegen den Anschlag des starren Schneidmessers 91 bildet. Mit 103 ist eine starre Platte bezeichnet, die der Führung des beweglichen Messers 101 und des Gegendrückers 102 dient. Das bewegliche Messer 101 ist über den Lagerblock 104 mit dem Gestänge 96 verbunden und weist einen Bolzen 105 auf, der in einem Aufsatz 106 des Gegendrückers 102 unter Vorspannung der Feder 107 geführt ist. Der Gegendrücker 102 wird zusammen mit dem beweglichen Messer 101 gegen das Bauteil 90 in der mit 89 bezeichneten Position vorgeschoben; der Gegendrücker hat dabei gegenüber dem beweglichen Messer einen Vorlauf. Damit wird das in der Position 89 festgelegte Bauteil von der Vorderkante des Gegendrückers 102 an den Anschlussdrähten 3 gegen den Anschlag 92 wirkend eingespannt und vorzentriert, so dass das Bauelement 90 eine vorgegebene Stellung an der Übergabeposition einnimmt. In dieser Stellung des Bauelementes 90 fährt die Bestückzange 108 zwischen die Anschlussdrähte 3 des Bauelementes und spannt die Anschlussdrähte ein. Bei weiterer Vorwärtsbewegung des beweglichen Schneidmessers 101 wird die Feder 107 gespeist, da der Gegendrücker 102 sich nicht mehr weiter nach vorne bewegt, und das bewegliche Messer 101 bewegt sich relativ zum Gegendrücker 102 bis in die Schneidposition, in der die unter dem Anschlag 92 vorstehenden Anschlussdrähte 3 des Bauteiles 90 mit dem Kartonteil 5 vom Bauteil 90 etwa 1 mm unter der Zange 108 abgeschnitten werden. Die Zange 108 führt anschliessend einen Aufwärtshub von ca. 2 mm aus.

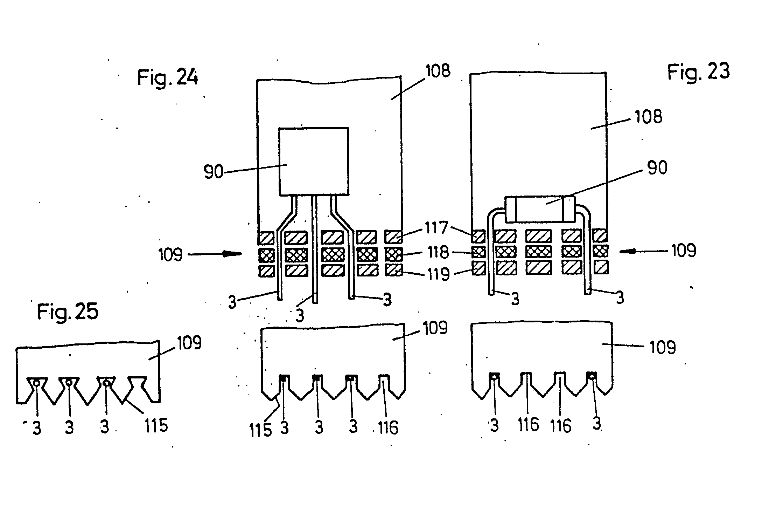

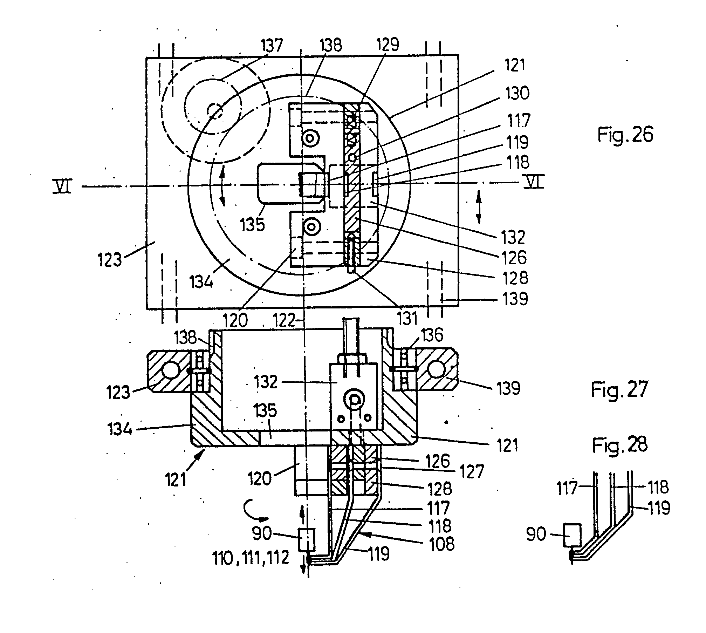

Die Bestückzange 108 weist einen Bestückzangenkopf 109 (Figuren 23 bis 25) auf, der so ausgebildet ist, dass er Aussparungen für die unterschiedlichen Anschlussdrähte 3 des Bauelementes besitzt. Beispielsweise ist in Fig. 23 ein Bauelement 90 mit zwei Anschlussdrähten 3 dargestellt, während in Fig. 24 ein Bauelement 90' mit drei Anschlussdrähten 3 dargestellt ist. Unabhängig von der Anzahl der Anschlussdrähte eines Bauelementes ist der Bestückzangenkopf 109 so ausgebildet, dass in gleicher Weise und ohne jede Umstellung Bauelemente mit einem, zwei, drei oder vier Anschlussdrähten aufgenommen werden können. Der Bestückzangenkopf 109 weist Einführerweiterungen 115 zum leichteren Einführen der Anschlussdrähte 3 auf, mit denen die Anschlussdrähte leichter in die nutenförmigen Vertiefungen 116 eingeführt werden können, in denen die Drähte 3 von dem Gegendrücker 102 eingespannt werden. Die Lamellen verlaufen von der Aufnahme- bzw. Einspannstelle des Bauelementes 90 weg im wesentlichen horizontal und gehen im Abstand von dieser Aufnahme bzw. Einspannstelle in die drei getrennten Arme 117, 118, 119 über, die in einer Bestückzangenhalterung 120 aufgenommen und voneinander versetzt angeordnet sind, damit die Bestückzange 108 eine hohe Steifigkeit erhält. Die Arme 117, 118, 119 sind aus der Aufnahme- bzw. Einspannebene des Bauelementes 90 versetzt angeordnet, wobei vorzugsweise der Arm 117 vertikal verläuft und die Arme 118 und 119 in unterschiedlichen Winkeln gegenüber dem vertikalen Arm 117 angeordnet sind. Der Arm 117 kann andererseits ebenfalls im Winkel geneigt angeordnet sein. Ebenso können der Arm 117 und/oder die Arme 118, 119 auch stufenweise aus der Horizontalen an den Lamellen in einen aufrechten Teil übergehen, wie in Fig. 28 dargestellt ist. Eine entsprechende Formgebung und Ausbildung der Arme ist in keiner Weise auf die dargestellten Ausführungsformen beschränkt. Ausschlaggebend für die Biegung bzw. Form dieser Arme ist, dass im Bereich oberhalb und seitlich von der Aufnahme- und Einspannstelle ein Freiraum entsteht, der es ermöglicht, Bauelemente mit der Bestückzange 108 auf engstem Raum in Printplatten einzusetzen, ohne dass benachbarte, bereits auf der Printplatte befindliche Bauelemente durch das Bestücken beschädigt werden können.

Die Arme 117 und 119 sind starr in der Bestückzangenhalterung 120 befestigt, der mittlere Arm 118 ist in der horizontalen Ebene beweglich angeordnet, damit eine eindeutige und einwandfreie Festlegung der Anschlussdrähte 3 in den Aussparungen 116 sichergestellt ist.

Die Bestückzangenhalterung 120 ist in einer Halterungsaufnahme in Form eines Drehkopfes 121 befestigt, der um eine vertikale Achse 122 drehbar ist. Der Bestückzangenkopf 109 der Bestückzange 108 wird zur Abnahme der Bauelemente 90 aus der Position 89 im Anschluss an das Abschneiden der Anschlussdrähte 3 auf endgültige Länge vertikal ca. 2 mm nach oben und dann horizontal von der Einspannstelle weg und vertikal nach unten in Pfeilrichtung der Pfeildarstellung 124 bewegt, während der horizontalen Bewegung kann auch eine Drehbewegung eingeleitet werden. Bei dieser Abwärtsbewegung werden die aus der Bestückzange 108 mit einer Zange von ca. 1 mm nach unten vorstehenden Drahtstummel der Anschlussdrähte 3 des Bauelementes 90 in die hierfür vorgesehenen Löcher in der Printplatte eingeführt. Anschliessend öffnet die Bestückzange 108, fährt aus dem Bauteil heraus und zurück in die Ausgangsposition. Während der Horizontalbewegung kann, falls dies erwünscht ist, eine Drehbewegung des Reststückkopfes durchgeführt werden.

Die Bestückzangenhalterung 120 nach Fig. 26 und 27 weist einen horizontalen Schieber 126 auf, der mittels Schraubbefestigung 127 starr mit dem beweglichen Arm 118 der Bestückzange befestigt ist. Ein starrer Deckel 128 nimmt den starren Arm 119 auf und dient als Gleitführung für den Schieber 126. Der Schieber 126 ist, wie in Fig. 26 mit Doppelpfeil dargestellt, in der Ebene der Anschlussdrähte 3 des Bauelementes 90 hin- und herbewegbar und nimmt bei dieser Bewegung den Arm 118 mit. Der Schieber 126 steht unter Wirkung einer Rückstellfeder 129, die sich an der Wandung der Bestückzangenhalterung 120 abstützt und in einer Bohrung 130 geführt ist. Auf dem der Feder 129 entgegengesetzten Ende des Schiebers 126 ist eine Einstellschraube 131 für den Schieber 126 vorgesehen. Am Bestückungskopf 60' ist ein Eindrücker zum Eindrücken der Bauelemente 90 in die Löcher der Printplatte 80 vorgesehen. Dieser Eindrücker wird von dem mit einer Gummikappe versehenen Ende eines Stössels 133 eines Druckluftzylinders 132 gebildet, wobei sich der die Bestückzange 108 tragende Drehkopf 121 relativ zum Stössel 133 in horizontaler Richtung um einen gewissen Betrag bewegen kann, um nach dem Einsetzen der Bauelemente 90 in die Printplatte 80 die Bestückzange 108 bzw.

deren Kopf 109 ausser Eingriff mit den Anschlussdrähten 3 bringen zu können. Mit 134 ist das Gehäuse des Drehkopfes 121 dargestellt, das eine Öffnung 135 besitzt, die von der U-förmigen Bestückzangenhalterung 120 teilweise umschlossen ist. Der Antrieb des Drehkopfes 121 erfolgt über einen Motor mit Zahnrad 137, dessen Verzahnung in den Zahnkranz 138 des Drehkopfes 121 antriebsmässig eingreift. Der Verstellschlitten 123 ist mit Hilfe von in Buchsen gelagerten Bolzen, Tragstiften oder dergl. als starre Achsen 139 in einem rahmenförmigen Träger 140 verschiebbar angeordnet, der einen Antriebsmotor 141 aufweist, welcher den Querschlitten 123 antreibt. Der Träger 140 ist integraler Bestandteil eines Schiebers 142, der über einen Antriebsmotor 143 eine Bewegung in Pfeilrichtung 144 ausführt und bei dieser Bewegung den Drehkopf in Pfeilrichtung 144 verschiebt. Mit dem Schieber 142 ist ein Schlitten 145 verbunden, der von einem Antriebsmotor 146 in Pfeilrichtung 147 angetrieben ist und der die Höhenbewegung des Drehkopfes 121 bewirkt. Durch die Antriebsmotoren 141, 143 und 146 wird somit eine Längsbewegung, eine seitliche Bewegung und eine Höhenbewegung des Drehkopfes 121 erreicht.

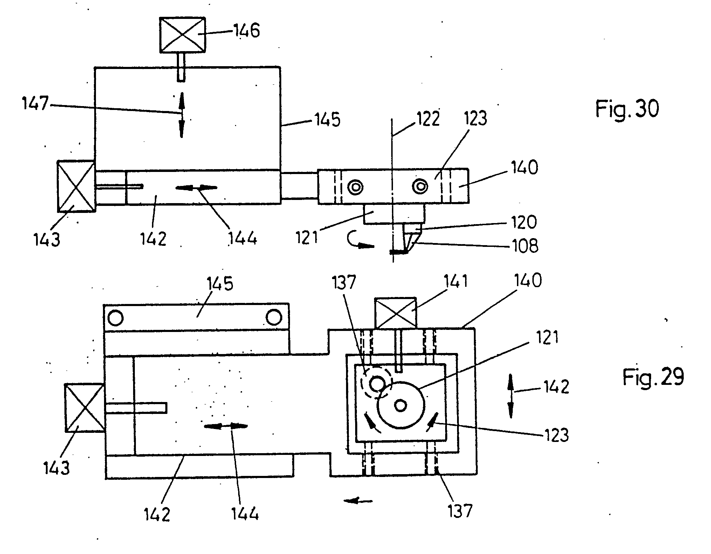

Die Figuren 29 und 30 zeigen in Draufsicht und Seitenansicht schematisch die Bestückzangenverstellung mit Antrieben. Mit 141 ist der Antriebsmotor für die Verstellung des Mittenversatzes der Bestückzangenhalterung 120 in der mit Pfeil 141' angegebenen Richtung dargestellt, 143 bezeichnet den Antriebsmotor für die horizontale Hin- und Herbewegung der Bestückzange in Richtung des Pfeiles 144 über den hin- und herbewegten Schlitten 142, und 146 den Antriebsmotor für die Höhenbewegung der Bestückzange 108 in Richtung des Pfeiles 147 über den Höhenschlitten 145, der mit den Schlitten 142 gekoppelt ist.

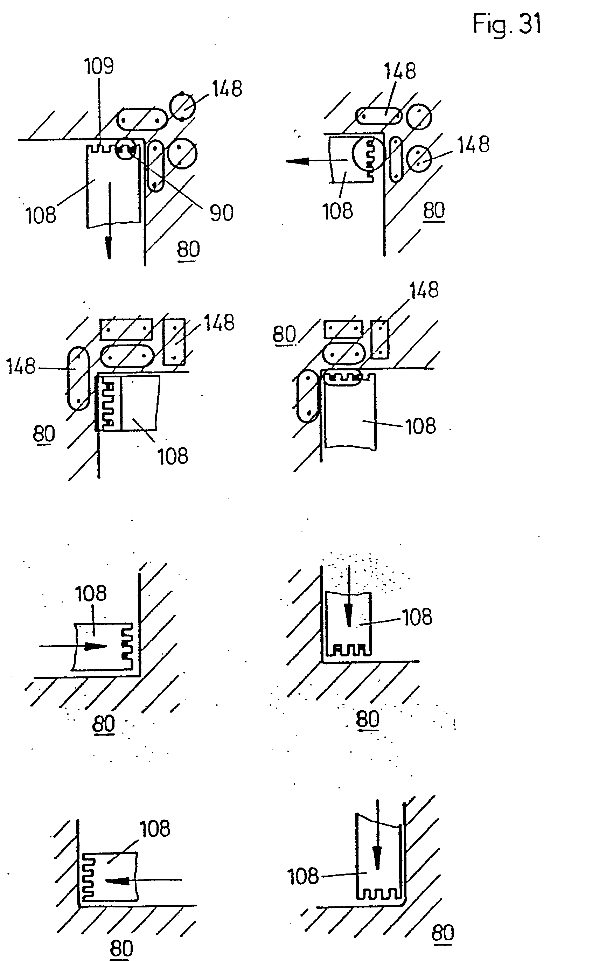

Fig. 31 zeigt anhand verschiedener Einsatzmöglichkeiten, wie mit der Bestückzange 108 praktisch in jede Ecke der Printplatte 80 hinein bestückt werden kann, so dass bei der Bestückung kein Platzverlust auf der Printplatte in Kauf genommen werden muss. Die Bestückzange 108 mit dem Bestückzangenkopf 109 ist schematisch angedeutet. Ebenfalls schematisch angedeutet sind die Anschlussdrähte 3 der in die Printplatte einzusetzenden Bauelemente 90 in der zu bestückenden Position gezeigt. Durch die Verdrehbarkeit der Bestückzange um 360° in der Printplattenachse bzw. Bestückachse kann das Bestücken der Printplatte 80 mit den verschiedenen und mit unterschiedli-chen Anschlussdrähten 3 versehenen Bauelemen-te von den geringsten Platzbedarf benötigen-den Seite aus vorgenommen werden. Hierbei sind mit 148 bereits in der Printplatte 80 bestückte Bauelemente angedeutet, von denen das Bauelement 90 einen möglichst engen Abstand aufweisen soll, damit die Packungsdichte auf der Printplatte 80 möglichst hoch wird.

Durch die universelle Beweglichkeit der Bestückzange 108, nämlich eine x-y-Bewegung in der horizontalen Ebene, eine Schwenkbewegung in der horizontalen Ebene und eine Höhenbewegung, ist es möglich, beim Bestücken den absolut geringsten Seitenabstand zu benachbarten Bauelementen zu erreichen, und damit eine maximale Packungsdichte zu erhalten.

Beispiel III

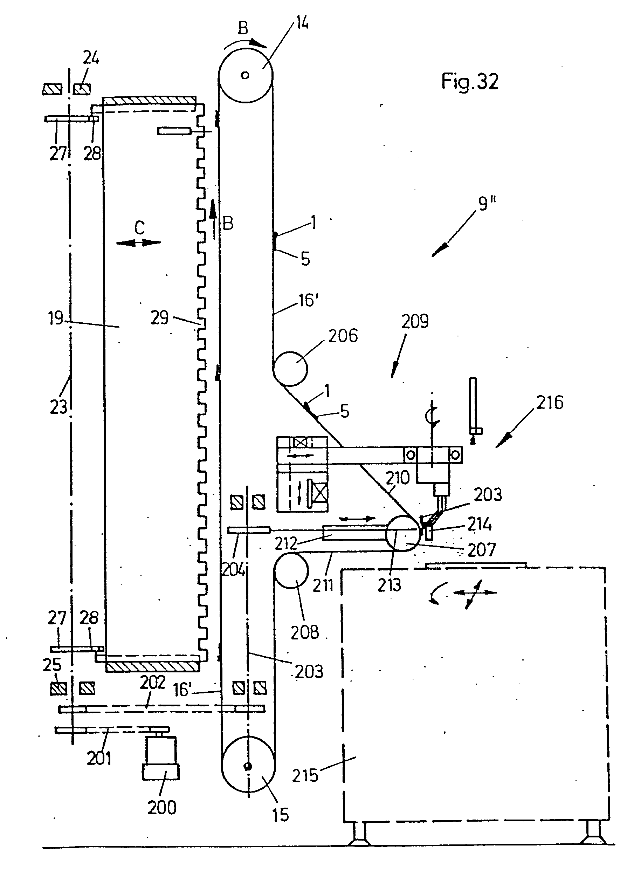

In der Fig. 32 ist in Seitenansicht eine weitere Vorrichtung 9" in Form eines Bestückungsautomaten gezeigt, bei dem die Einrichtung der Sequenzbildung wie bei der Vorrichtung 9 der Fig. 1 bis 16 ausgebildet ist und insbesondere das Transportelement 16 mit seinen Längen 16' vertikal angeordnet ist. Die Vorrichtung 9" unterscheidet sich von der Vorrichtung 9 hinsichtlich der Einrichtung zur Sequenzbildung lediglich dadurch, dass wiederum nur ein einziger Schneidbalken 19 vorgesehen ist. Ein Antriebsmotor 200 ist über einen Ketten- oder Riementrieb 201 mit der Welle 23 verbunden. Über einen weiteren Ketten- oder Riementrieb 202 ist mit der Welle 23 eine Welle 203 antriebsmässig verbunden, die zumindest eine in ihrer Position der Steuerkurve 93 der Vorrichtung 9' entsprechende Kurven- oder Steuerscheibe 204 zum Antrieb der am Bestückungskopf 60' vorgesehenen Messeranordnung trägt. Die eine Länge 16' des Transportelementes 16 ist über Umlenkrollen 206, 207 und 208 so umgelenkt, dass ein Transportelementabschnitt 209 entsteht, der eine schräg nach unten verlaufende Teillänge 210 sowie eine sich daran anschliessende horizontale Teillänge 211 aufweist. An der Umlenkrolle 207 stehen die Bauelemente 1 in vertikaler Position und hier erfolgt analog der Darstellung nach Fig. 20 das Einspannen, das Vorzentrieren, Abschneiden der Bauelemente 1 sowie Positionieren der Bestückzange zur Printplatte, wie dies bereits bei der Vorrichtung 9' (Fig. 17 bis 31) beschrieben wurde. Lediglich der Vollständigkeit halber sind begegli-che Schneidmesser 212, Gegendrücker 213 und starres Schneidmesser 214 der Schneidvorrichtung zum Abtrennen der Bauelemente 1 von den Gurtabschnitten 5 bei der Übergabe an die Bestückzange angedeutet, ebenso auch der X-Y-Tisch 215 sowie der Bestückungskopf 216, der dem Bestückungskopf 60' der Vorrichtung 9' voll entspricht.

**Patentansprüche**

1. Vorrichtung zur automatischen Verarbeitung elektrischer Bauelemente, bestehend aus einer ersten Einrichtung zur Sequenzbildung, in der die Bauelemente in Magazinen auf mehreren Gurten mit Perforationslöchern in radial gegurteter Form bereit stehen, wobei jeder Gurt Bauelemente des gleichen Typs trägt, und in der die Bauelemente programmgesteuert an Ladepositionen aus den Magazinen abgerufen und in eine für die Bestükkung einer elektrischen Schaltung erforderlichen Sequenz mit Hilfe eines Transportelementes an eine Übergabestation gefördert werden, an der die Bauelemente an eine zweite Einrichtung zur Weiterverarbeitung übergeben werden, wobei für die Übergabe jedes Bauelementes an das getaktet umlaufende Transportelement der betreffende Gurt jeweils zwischen diesem Bauelement und einem nachfolgenden Bauelement mittig an einem Perforationsloch quer zur Gurtlängsrichtung abgeschnitten und der dadurch erhaltene, ein Bauelement tragende Gurtabschnitt derart an das Transportelement übergeben wird, dass der Gurtabschnitt an seinen Lochlaibungen an Aufnahmen des Transportelementes zentriert und festgehalten ist, dadurch gekennzeichnet, dass die Transportrichtung (B) der abgeschnittenen Bauelemente (1) auf dem Transportelement (16) in Achsrichtung der Anschlussdrähte (3) dieser Bauelemente (1) in Gurtebene und quer zur Gurtlaufrichtung liegt.

2. Vorrichtung nach Anspruch 1, dadurch gekennzeichnet, dass das Transportelement (16) ein endloses ketten-, band- oder riemenartiges Element ist.

3. Vorrichtung nach Anspruch 2, dadurch gekennzeichnet, dass das Transportelement (16) leiterförmig ausgebildet ist und aus zwei parallel zueinander und im Abstand voneinander angeordneten in sich geschlossenen ketten- oder bandförmigen Einzelelementen, vorzugsweise Zahnriemen (17) besteht, die durch quer zur Transportrichtung (B) des Transportelementes (16) liegende Stege (18) miteinander verbunden sind, wobei zumindest ein Teil dieser Stege (18) Aufnahmen für die Gurtabschnitte (3) vorzugsweise in Form von Zapfen (36, 37) aufweist, zwischen denen die Gurtabschnitte (5) an ihren Lochlaibungen (8) gehaltern sind, und wobei zwischen den einzelnen Stegen (18) in Transportrichtung ein Freiraum für die Aufnahme der Bauelemente (4) gebildet ist.

4. Vorrichtung nach einem der Ansprüche 1 bis 3, dadurch gekennzeichnet, dass das Transportelement (16) von einem vorzugsweise von Maschinenantrieb getrennten, aber mit diesen synchron gesteuerten Antrieb angetrieben ist, welcher ein Vor- und Rückwärtsfahren des Transportelementes (16) und ein genaues Anfahren verschiedener Ladepositionen vom Maschinentakt bei Maschinenstillstand ermöglicht.

5. Vorrichtung nach einem der Ansprüche 1 bis 4, dadurch gekennzeichnet, dass zur Bildung einer mehreren Ladepositionen gemeinsamen Schneideinrichtung wenigstens ein beweglicher Messerbalken (19) vorgesehen ist, der sich in Transportrichtung (B) des Transportelementes (16) erstreckt und der im Takt der Zuführung der Gurte (12) an die Ladepositionen eine Schneidbewegung gegenüber wenigstens einem starren Schneidmesser (38) programmgesteuert im Takt der Zuführung der Gurte (12) ausführt.

6. Vorrichtung nach einem der Ansprüche 1 bis 5, gekennzeichnet durch eine Gurtbremse (45, 46, 47, 48, 49, 50, 51, 52) an jeder Ladeposition.

7. Vorrichtung nach einem der Ansprüche 1 bis 6, gekennzeichnet durch Mittel zum programmgesteuerten und getakteten Zuführen der die Bauelemente (1) tragenden Gurte (12) an die Ladepositionen, wobei diese Mittel von wenigstens einer, für mehrere Ladepositionen bzw. Gurte (12) gemeinsamen, wenigstens eine Wippe (30) aufweisenden Wippenanordnung gebildet ist, wobei die Wippe (30) Druckzylinder mit Stösseln (33) besitzt, die im Takt der Maschine nach Rechnerprogramm in die Perforationslöcher (8) der Gurte (12) eingreifen und den jeweils gewünschten Gurt (12) oder die jeweils gewünschten Gurte (12) bei einer Wippenbetätigung um einen Abstand, den zwei Perforationslöcher (8') voneinander aufweisen, weiterbewegen.

8. Vorrichtung nach Anspruch 7, dadurch gekennzeichnet, dass die Wippenanordnung zwei spiegelbildlich zum Schneidmesser (29) angeordnete Wippen (30) aufweist.

9. Vorrichtung nach einem der Ansprüche 1 bis 8, dadurch gekennzeichnet, dass in Transportrichtung (B) des Transportelementes (16) auf die letzte Ladeposition folgend am Transportelement (16) eine Messvorrichtung (58) vorzugsweise mit Kontaktfingern und Messlehre sowie eine Abstreifvorrichtung (61) vorgesehen sind.

10. Vorrichtung nach einem der Ansprüche 1 bis 9, dadurch gekennzeichnet, dass bei Ausbildung der Vorrichtung zum Umgurten der Bauelemente (1) in eine für die Bestückung einer Schaltung erforderlichen Sequenz die an der Übergabestation (59) vorgesehene zweite Einrichtung eine Aufgurtstation (60) ist, die ein mit Aufnahmen, vorzugsweise in Form von Zapfen (49) für die Gurtabschnitte (5) versehenes weiteres Transportelement (66) aufweist.

11. Vorrichtung nach Anspruch 10, dadurch gekennzeichnet, dass das weitere Transportelement (66) von einem riemen-, band- oder kettenartigen Element, insbesondere Zahnriemen gebildet ist, dessen Transportrichtung (E) zumindest an der Übergabeposition (59) senkrecht zur Transportrichtung (B) des ersten Transportelementes (16) verläuft und welches getaktet und synchron mit dem ersten Transportelement (16) angetrieben bei jeder Stillstandsphase mit einer ebenfalls Zapfen (70) zum Halten und Fixieren der Gurtenabschnitte (5) an ihren Lochlaibungen (8) aufweisenden Aufnahme (69) einer Aufnahme (18) des ersten Transportelementes (16) unmittelbar gegenüberliegt, und dass die Gurtabschnitte (5) am weiteren Transportelement (66) an ihren Schnittkanten unmittelbar gegeneinander anliegend gehalten sind.

12. Vorrichtung nach einem der Ansprüche 1 bis 9, dadurch gekennzeichnet, dass die zweite Einrichtung (U) zur weiteren Verarbeitung ein Bestückungskopf zur Bestückung einer elektrischen Schaltung mit einer zangenartigen Bestückvorrichtung oder einer Bestückzange (108) ist, die an einer Halterung (121) befestigt ist, welche um eine vertikale Achse (122) drehbar und/oder in horizontaler Richtung in der Ebene der Anschlussdrähte (3) des Bauelementes (90) und/oder senkrecht zu dieser Ebene verschiebbar und/oder in vertikaler Richtung heb- und senkbar ist.

**Claims**

1. Apparatus for the automatic processing of electric components, comprising a first device for sequence formation, in which the components are ready in magazines on several belts with perforation holes in radially belted form each belt bearing components of the same type, and in which the components are called under program control from the magazines into loading positions and are conveyed in a sequence necessary for the equipping of an electric circuit with the aid of a transport element to a transfer station, at which the components are transferred to a second device for further processing, the belt concerned being cut off in each case, for the transfer of each component to the cyclically circulating transport element, between this component and a subsequent component midway at a perforation hole transversely to the longitudinal direction of the belt, and the belt section thereby obtained, bearing a component, is transferred to the transport element in such a way that the belt section is centred and held in place at the insides of its holes on receivers of the transport element, characterized in that the transport direction (B) of the cut-off components (1) on the transport element (16) lies in axial direction of the connecting wires (3) of these components (1) in the plane of the belt and transversely to the running direction of the belt.

2. Apparatus according to claim 1, characterized in that the transport element (16) is an endless chain-like, band-like or belt-like element.

3. Apparatus according to claim 2, characterized in that the transport element (16) is designed in the form of a ladder and comprises two mutually parallel and spaced apart, self-contained individual elements in chain or band form, preferably toothed belts (17) which are interconnected by crossmembers (18) lying transversely to the transport direction (B) of the transport element (16), at least part of these crossmembers (18) having receivers for the belt section (3), preferably in the form of pins (36, 37), between which the belt sections (5) are retained at the insides of their holes (8), and a clearance being formed between the individual crossmembers (18) in transport direction for the reception of the components (4).

4. Apparatus according to one of claims 1 to 3, characterized in that the transport element (16) is driven by a drive which is preferably separate from the machine drive but is controlled synchronously with the latter, and which makes possible a forward and reverse travelling of the transport element (16) and an exact approach to various loading positions of the machine cycle at machine standstill.

5. Apparatus according to one of claims 1 to 4, characterized in that, for forming a cutting device common to several loading positions, at least one movable cutter bar (19) is provided, which extends in transport direction (B) of the transport element (16) and, in time with the feed of the belts (12) to the loading positions, executes a cutting movement with respect to at least one rigid cutter (38) under program control in time with the feed of the belts (12).

6. Apparatus according to one of claims 1 to 5, characterized by a belt brake (45, 46, 47, 48, 49, 50, 51, 52) at each loading position.

7. Apparatus according to one of claims 1 to 6, characterized by means for the program-controlled and clocked feeding of the belts (12) bearing the components (1) to the loading positions, these means being formed by at least one common rocker arrangement for several loading positions or belts (12), having at least one rocker (30), the rocker (30) possessing compression cylinders with push rods (33), which engage in the perforation holes (8) of the belts (12) in time with the machine on the basis of a computer program and advance the particularly required belt (12) or the particularly required belts (12) on a rocker actuation by a distance which two perforation holes (8') have from each other.

8. Apparatus according to claim 7, characterized in that the rocker arrangement has two rockers (30) arranged mirror-invertedly with respect to the cutter (29).

9. Apparatus according to one of claims 1 to 8, characterized in that a measuring apparatus (58), preferably with contact fingers and gauge, as well as a stripping apparatus (61) are provided at the transport element (16) following the last loading position in transport direction (B) of the transport element (16).

10. Apparatus according to one of claims 1 to 9, characterized in that, when designing the apparatus for the belt-transfer of the components (1) into a sequence necessary for the equipping of a circuit, the second device provided at the transfer station (59) is a belting station (60), which has a further transport element (66) provided with receivers, preferably in the form of pins (49), for the belt sections (5).

11. Apparatus according to claim 10, characterized in that the further transport element (66) is formed by a belt-like, band-like or chain-like element, in particular toothed belts, the transport direction (E) of which runs, at least, the transport direction (E) of which runs, at least at the transfer position (59), perpendicularly to the transport direction (B) of the first transport element (16) and which, driven cyclically and synchronously with the first transport element (16) in each standstill phase, lies with a receiver (69), likewise having pins (70) for retaining and fixing the belt sections (5) at the insides of their holes (8), directly opposite a receiver (18) of the first transport element (16), and in that the belt sections (5) are retained on the further transport element (66) at their cut edges which directly adjoin.

12. Apparatus according to one of claims 1 to 9, characterized in that the second device (U) for further processing is an equipping head for the equipping of an electric circuit with a tongs-like equipping apparatus or a pair of equipping tongs (108) which is fixed on a holder (121) which is rotatable about a vertical axis (122) and/or can be displaced in horizontal direction in the plane of the connecting wires (3) of the component (90) and/or perpendicularly to this plane and/or can be raised and lowered in vertical direction.

## Revendications

1. Dispositif de traitement automatique de composants électriques constitué d'un premier dispositif, de formation de séquence, dans lequel les composants sont en attente dans des magasins, disposés radialement sur plusieurs bandes pourvues de perforations, chaque bande portant des composants du même type, et dans lequel les composants sont appelés des magasins à des emplacements de chargement par commande par programme et conduits par un élément transporteur, en une séquence nécessaire pour l'equipement d'un circuit électrique, à un poste de transfert où ils sont transférés à un deuxième dispositif de traitement ultérieur, la bande, pour le transfert de chaque composant à l'élément transporteur tournant en cadence, étant coupéeau milieu entre ce composant et un composant suivant, à l'emplacement d'une perforation, perpendiculairement à sa direction longitudinale et le tronçon de bande ainsi obtenu portant un composant étant transféré à l'élément transporteur de façon telle qu'il soit centré et fixé par ses demi-perforations ou encoches sur des éléments récepteurs de l'élément transporteur, caractérisé en ce que la direction de transport (B) des composants détachés (1) sur· l'élément transporteur (16) est identique à la direction axiale des fils de connexion (3) de ces composants (1) dans le plan de la bande et perpendiculaire à la direction de marche de la bande.

2. Dispositif selon la revendication 1, caractérisé en ce que l'élément transporteur (16) est un élément sans fin du type chaîne, bande ou courroie.

3. Dispositif selon la revendication 2, caractérisé en ce que l'élément transporteur (16) est en forme d'échelle et constitué de deux éléments sans fin en forme de chaîne ou de bande, de préférence de courroies dentées (17), parallèles espacés qui sont réunis par des entretoises (18) perpendiculaires à la direction de mouvement (B) de l'élément transporteur (16), au moins une partie de ces entretoises (18) présentant pour les tronçons de bande (5) des éléments récepteurs de préférence formés de tenons (36, 37) entre lesquels les tronçons de bande (5) sont tenus à leurs encoches (8), et entre les différentes entretoises (18) étant formés, dans la direction de transport, des espaces libres destinés à recevoir les composants (4).

4. Dispositif selon l'une des revendications 1 à 3, caractérisé en ce que l'élément transporteur (16) est entraîné par un dispositif d'entraînement de préférence distinct du dispositif d'entraînement de la machine, mais commandé en synchronisme avec celui-ci, qui permet une marche en avant et en arrière de l'élément transporteur (16) et un accostage précis à différents emplacements de chargement de la marche en cadence de la machine à l'arrêt de la machine.

5. Dispositif selon l'une des revendications 1 à 4, caractérisé en ce que, pour la formation d'un dispositif de coupe commun à plusieurs emplacements de chargement, il est prévu au moins une barre mobile à couteaux (19) qui s'étend dans la direction de mouvement (B) de l'élément transporteur (16) et qui exécute à la cadence d'amenée des bandes (12) aux emplacements de chargement, par commande par programme à la cadence d'amenée des bandes (12), un mouvement de coupe par rapport à au moins une lame fixe (38).

6. Dispositif selon l'une des revendications 1 à 3, caractérisé par un frein de bande (45, 46, 47, 48, 49, 50, 51, 52) à chaque emplacement de chargement.

7. Dispositif selon l'une des revendications 1 à 6, caractérisé par des moyens d'amenée, commandée par un programme et cadencée, des bandes (12) portant les composants (1) aux emplacements de chargement, ces moyens étant formés d'un dispositif à bascule (s) commun à plusieurs emplacements de chargement ou bandes (12) et présentant au moins une bascule (30), cette bascule comportant des vérins ayant des tiges (33) qui s'engagent à la cadence de la machine, suivant un programme d'ordinateur, dans les perforations (8) des bandes (12) et, lors d'un actionnement de la bascule, avancent la bande désirée (12) ou les bandes désirées (12) d'une quantité correspondant à la distance de deux perforations (8').

8. Dispositif selon la revendication 7, caractérisé en ce que le dispositif à bascules présente deux bascules (30) placées symétriquement par rapport au couteau (29).

9. Dispositif selon l'une des revendications 1 à 8, caractérisé en ce qu'après le dernier emplacement de chargement dans le sens de mouvement (B) de l'élément transporteur (16) sont prévus sur ce dernier un dispositif de mesure (58) de préférence à doigts de contact et jauge et un dispositif éjecteur (61).

10. Dispositif selon l'une des revendications 1 à 9, caractérisé en ce que lorsqu'il est conçu pour la remise en bande des composants (1) dans une séquence nécessaire à l'équipement d'un circuit, le deuxième dispositif, prévu au poste de transfert (59), est un poste de mise en bande (60) qui comporte un autre élément transporteur (66) pourvu d'éléments récepteurs, de préférence formés de tenons (49), pour les tronçons de bande (5).

11. Dispositif selon la revendication 10, caractérisé en ce que l'autre élément transporteur (66) est formé d'un élément du type courroie, bande ou chaîne, en particulier d'une courroie dentée, dont la direction de mouvement (E) est, au moins au poste de transfert (59), perpendiculaire à la direction de mouvement (B) du premier élément transporteur (16) et qui, mû en cadence et en synchronisme avec le premier élément transporteur (16), a, à chaque phase d'arrêt, un récepteur (69), qui présente également des tenons (70) destinés à tenir et fixer les tronçons de bande (5) à leurs encoches (8), situé directement en face d'un récepteur (18) du premier élément transporteur (16), et que sur cet autre élément transporteur (66), les tronçons de bande (5) sont placés les uns contre les autres, en contact par leur bord de coupe.

12. Dispositif selon l'une des revendications 1 à 9, caractérisé en ce que le deuxième dispositif (U) de traitement ultérieur, est une tête d'équipement de circuit électrique comportant un dispositif d'équipement du type pince ou une pince d'équipement (108) qui est fixé (e) à un support (121) qui peut tourner autour d'un axe vertical (122) et/ou se déplacer dans la direction horizontale dans le plan des fils de connexion (3) du composant (90) et/ou se déplacer perpendiculairement à ce plan et/ou monter et descendre verticalement.

Fig.1

```
┌─────┐   ┌─────┐
│  M  │   │  M  │
└──┬──┘   └──┬──┘
   │         │
   ▼         ▼
┌─────────────────────┐      ┌─────┐
│                     │      │     │
│          S          │ ───▶ │  U  │
│                     │      │     │
└──▲─────────────▲────┘      └─────┘
   │             │
┌──┴──┐       ┌──┴──┐
│  M  │       │  M  │
└─────┘       └─────┘
```

Fig.3a

Fig. 2

Fig. 3

Fig. 4

Fig. 5

Fig.12

48 (47)  48 (47)  48(47)

50(49)

52 (51)  5  1  57  57  1

Fig.6  Schnitt I-I  Fig.7

Schnitt II-II

17  II  36  37  18
17
17"
17ˣ  18'

17  36
18
17'  18'

18  36  37  18

Fig.8

18'

Fig. 9

Fig. 10

Fig. 11

Fig. 13

Fig. 14

Fig. 15

Fig. 16

Fig.17

Fig.18

Fig. 19

Fig. 20

Fig. 21

Fig. 22

Fig. 23

Fig. 24

Fig. 25

108 90 109 3 3 109 116 116 116 3 3

117 118 119

108 90 109 3 3 3 109 116 3 3 115 3

109 115 3 3 3

Fig.26

Fig.27

Fig.28

Fig.30

Fig.29

Fig. 31

Fig. 32

Fig. 33